# EUROPEAN PATENT SPECIFICATION

(11) **EP 4 494 879 B1**
(45) Date of publication and mention of the grant of the patent: **26.08.2026**
(21) Application number: 22932093.2
(22) Date of filing: 17.03.2022
(51) Int. Cl.: B41J 2/14, B41J 2/16, H10P 50/64

(54) **NOZZLE PLATE, DROPLET DISCHARGE HEAD, DROPLET DISCHARGE DEVICE, AND PRODUCTION METHOD FOR NOZZLE PLATE**
DÜSENPLATTE, TRÖPFCHENAUSSTOSSKOPF, TRÖPFCHENAUSSTOSSVORRICHTUNG UND HERSTELLUNGSVERFAHREN FÜR DÜSENPLATTE
PLAQUE DE BUSE, TÊTE DE DÉCHARGE DE GOUTTELETTES, DISPOSITIF DE DÉCHARGE DE GOUTTELETTES ET PROCÉDÉ DE PRODUCTION POUR PLAQUE DE BUSE

(43) Date of publication of application: 22.01.2025
(73) Proprietor: KONICA MINOLTA, INC., Tokyo 100-7015 (JP)
(72) Inventor: OGAWA, Yoshiyuki, Tokyo 100-7015 (JP); KAJITA, Hiroshi, Tokyo 100-7015 (JP)
(74) Representative: MFG Patentanwälte Meyer-Wildhagen Meggle-Freund Gerhard PartG mbB
(86) International application number: PCT/JP2022/012125
(87) International publication number: WO 2023/175817

(56) References cited:
- JP-A- 2007 322 615
- JP-A- 2008 105 418
- JP-A- 2008 307 838
- JP-A- H1 067 115
- JP-B2- 3 564 853

## Description

### Technical Field

The present invention relates to a nozzle plate, a droplet ejection head, a droplet ejecting apparatus, and a nozzle plate manufacturing method.

### Background Art

As a method of manufacturing a nozzle plate of a droplet ejection head included in a droplet ejecting apparatus, there has been known a method of forming a nozzle channel by performing anisotropic wet etching on a single-crystal silicon substrate (e.g., refer to Patent Documents 1 to 3, 5 and 6). Patent Document 4 mentions etching for forming nozzles.

### Citation List

### Patent Literature

Patent Document 1: Japanese Patent No. 5519263
Patent Document 2: JP 3 564853 B2
Patent Document 3: JP H10 67115 A
Patent Document 4: JP 2007 322615 A
Patent Document 5: JP 2008 307838 A
Patent Document 6: JP 2008 105418 A

### Summary of Invention

### Technical Problem

When anisotropic wet etching is performed on a single-crystal silicon substrate whose surface has the crystal orientation of a {100} plane, corrosion proceeds in a certain direction. Therefore, it is possible to form only a nozzle channel in which the opening of the surface facing the droplet ejection surface is square. As a result, in a case where a plurality of nozzle channels is arranged side by side in a single-crystal silicon substrate, the number of nozzle channels is smaller in a nozzle channel having a square opening than in a nozzle channel having an elongated opening.

The present invention has been made in view of such circumstances. An object of the present invention is to provide a nozzle plate, a droplet ejection head, a droplet ejecting apparatus, and a nozzle plate manufacturing method that can increase the density of nozzles.

### Solution to Problem

According to a first aspect, the present invention provides a nozzle plate according to independent claim 1. According to a second aspect, the present invention provides a nozzle plate according to independent claim 3. According to a third aspect, the present invention provides a droplet ejection head according to independent claim 9. According to a fourth aspect, the present invention provides a droplet ejection apparatus according to independent claim 10. According to a fifth aspect, the present invention provides a method for manufacturing a nozzle plate of a droplet ejection head according to independent claim 11. According to a sixth aspect, the present invention provides a method for manufacturing a nozzle plate of a droplet ejection head according to independent claim 12. Further aspects of the present invention are set forth in the dependent claims, the drawings and the following description.

### Advantageous Effects of Invention

According to the nozzle plate, the droplet ejection head, the droplet ejecting apparatus, and the nozzle plate manufacturing method of the present invention, both high density of nozzles and preferable ejection characteristics can be achieved.

### Brief Description of Drawings

[FIG. 1] This is a schematic perspective view of a droplet ejecting apparatus according to the present embodiment.
[FIG. 2] This is a schematic side cross-sectional view of a droplet ejection head according to the present embodiment.
[FIG. 3A] This is an enlarged plan view of a nozzle plate illustrating a nozzle channel according to the present embodiment.
[FIG. 3B] This is a side cross-sectional view of the nozzle plate taken along a line IIIB-IIIB in FIG. 3A.
[FIG. 3C] This is a perspective cross-sectional view of the nozzle plate illustrating the nozzle channel according to the present embodiment.
[FIG. 4] This is an enlarged plan view of a nozzle plate illustrating a nozzle channel according to another embodiment.
[FIG. 5] This is a cross-sectional view of a nozzle plate illustrating main steps of a method for manufacturing a nozzle plate according to the first embodiment.
[FIG. 6] This is a cross-sectional view of a nozzle plate illustrating main steps of a method for manufacturing a nozzle plate according to a modification example of the first embodiment.
[FIG. 7] This is a cross-sectional view of a nozzle plate illustrating main steps of a method for manufacturing a nozzle plate according to the second embodiment.
[FIG. 8] This is a cross-sectional view of a nozzle plate illustrating main steps of a method for manufacturing a nozzle plate according to the third embodiment.
[FIG. 9] This is a cross-sectional view of a nozzle plate illustrating the relationship of a deep hole formed in the eighth step of the method for manufacturing the nozzle plate according to the third embodiment.

### Description of Embodiments

In the following, preferred embodiments of the present invention will be described with reference to the drawings. However, the scope of the invention is not limited to the illustrated examples. In the following description, components having the same function and configuration are denoted by the same reference numerals, and description thereof is omitted.

The Miller index that describes the crystal plane and the direction generally has the following convention, and the present specification also complies with the convention.
(h kl): a specific plane
{h k l}: equivalent planes
[h k l]: a specific direction
<h k l>: equivalent directions

Furthermore, unless otherwise specified, examples in the specification assume the following.

The surface on the bonding side of a wafer surface: the (110) plane

The surface on the ejection side of a wafer surface: the (-1-10) plane

The two tapered surfaces of the four surfaces that constitute a nozzle tapered portion: the (-1-11) plane and the (-1-1-1) plane

The vertical surfaces of the four surfaces that constitute a nozzle tapered portion and the two facing surfaces having longer sides among the four surfaces that constitute a straight communication path: the (-111) plane and the (1-1-1) plane

The two facing surfaces having shorter sides among the four surfaces that constitute the straight communication path: the (1-11) plane and the (-11-1) plane

However, as a matter of course, the present invention is not limited to this description as long as the plane and direction are equivalent to the described contents.

### [Inkjet Recording Apparatus]

First, as a droplet ejecting apparatus according to the present embodiment, an example of the configuration of an inkjet recording apparatus 1 that includes an inkjet head 10, which is a droplet ejection head, is disclosed. In the following description, as shown in the drawings, the conveyance direction of a recording medium PD in the inkjet recording apparatus 1 is referred to as the front-rear direction. The direction perpendicular to the conveyance direction on the conveyance surface of the recording medium PD is referred to as the left-right direction. The direction perpendicular to the front-rear direction and the left-right direction (ink ejection direction) is referred to as the up-down direction. The inkjet head 10 is described with reference to the direction in which the inkjet head 10 is mounted on the inkjet recording apparatus 1.

Unless otherwise specified, the above-mentioned plane orientation of the wafer is followed, and the following is assumed in description.
Up: [110] direction
Down: [-1-10] direction
Left: [-111] direction
Right: [1-1-1] direction
Front: [1-12] direction
Rear: [-11-2] direction

However, as a matter of course, the present invention is not limited to this description as long as the plane and direction are equivalent to the described contents.

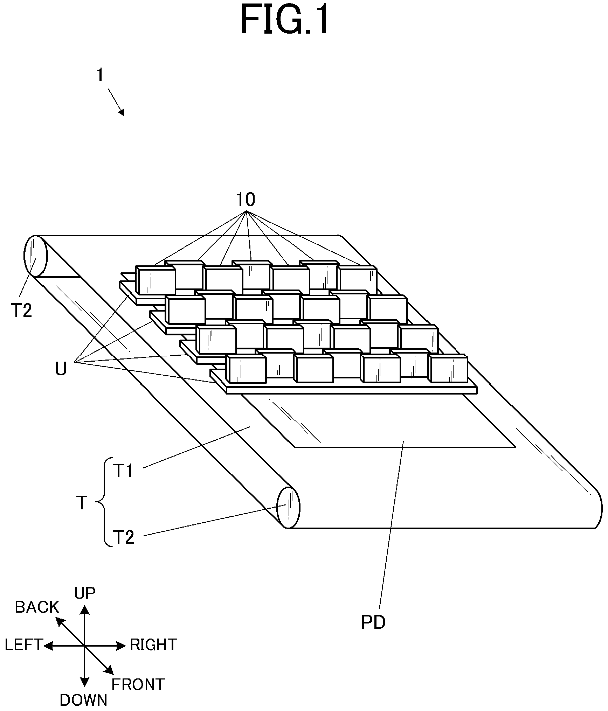

FIG. 1 is a schematic perspective view of the inkjet recording apparatus 1 according to the present embodiment. The inkjet recording apparatus 1 conveys the recording medium PD, such as a sheet, in the front-rear direction through a plurality of units U by a conveyance section T. The conveyance section T includes, for example, a conveyance belt T1 and conveyance rollers T2. In each of the plurality of units U, a plurality of inkjet heads 10 are disposed. Each of the plurality of units U ejects ink of each color from each of the plurality of inkjet heads 10 to print an image on the recording medium PD.

### [Inkjet Head]

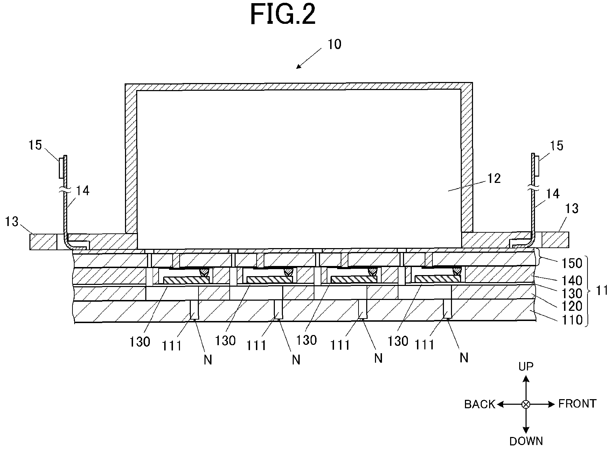

FIG. 2 is a schematic side cross-sectional view of one of the inkjet heads 10 as viewed from the side. The inkjet head 10 includes a head chip 11, a common ink chamber 12, a support substrate 13, wires 14, and a drive section 15. FIG. 2 shows a cross section of the inkjet head 10 in a plane including four nozzles N.

### [Head Chip]

The head chip 11 is configured to eject ink from the nozzles N. The head chip 11 is formed by stacking a plurality of plate-like substrates (four substrates in FIG. 2). The downmost plate in the head chip 11 is a nozzle plate 110.

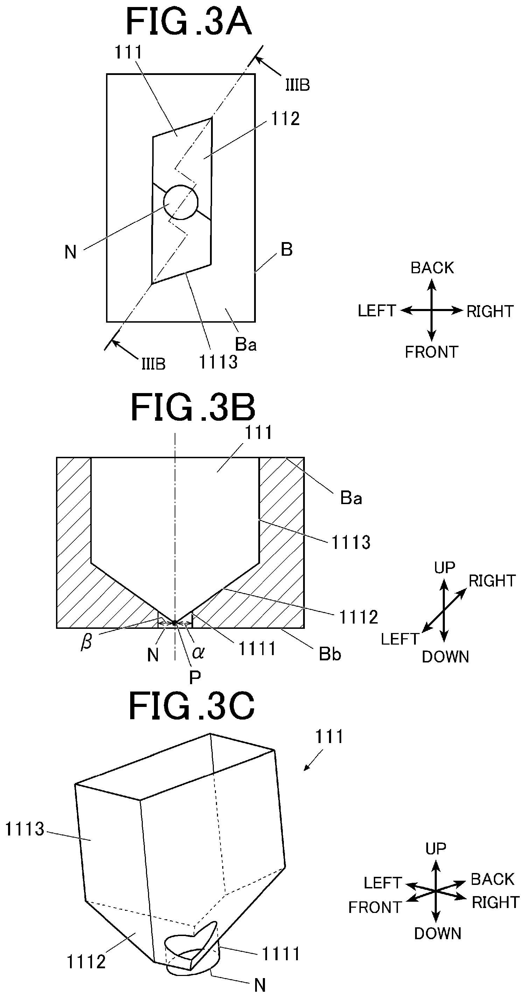

On the bonding surface (first surface) Ba of the nozzle plate 110 (see FIG. 3B), a piezoelectric material plate 120, a vibration plate 130, a spacer substrate 140, and a wiring substrate 150 are bonded and stacked in this order upward, for example. The nozzle plate 110 is provided with a plurality of nozzle channels 111 having a structure according to the present invention. The nozzle plate 110 is capable of ejecting ink substantially vertically to the ejection surface (second surface) Bb (see FIG. 3B) from the nozzles N that are openings of the nozzle channels 111. The ejection surface (second surface) Bb is an exposed surface of the nozzle plate 110 and faces the bonding surface Ba.

The piezoelectric material plate 120, the vibration plate 130, the spacer substrate 140, and the wiring substrate 150 are provided with ink channels that communicate with the nozzles N. The ink channels are opened on the surface of the wiring substrate 150 on the exposed side (upward side). On the exposed surface of the wiring substrate 150, the common ink chamber 12 is provided to cover all the openings.

Ink stored in an ink chamber forming member (not illustrated) of the common ink chamber 12 is supplied to each of the nozzles N from the respective openings of the wiring substrate 150 via the respective ink channels. Then, a pressure chamber provided so as to penetrate the piezoelectric material plate 120 is deformed together with the vibration plate 130 by the displacement (deformation) of a piezoelectric element in a storage section adjacent to the pressure chamber, thereby applying a pressure change to the ink. As a result, the ink is ejected downward from the nozzles N as droplets.

In the head chip 11, it is preferable that the openings of the ink channels on the bonding surface of each plate have similar shapes to each other, and it is more preferable that the openings have the same shape.

The nozzle plate 110 is not limited to the configuration of being bonded to the piezoelectric material plate 120. That is, another plate may be provided between the nozzle plate 110 and the piezoelectric material plate 120. The method of combining the nozzle plate 110 with another plate may be bonding or joining and is not limited thereto.

### [Nozzle Plate]

FIG. 3A is an enlarged plan view illustrating one of the nozzle channels 111 when the nozzle plate 110 is viewed from the side of the bonding surface Ba. FIG. 3B is a cross-sectional view of the nozzle channel 111 taken along a line IIIB-IIIB in FIG. 3A. FIG. 3C is a perspective cross-sectional view of the nozzle channel 111. The nozzle plate 110 is provided, in a single-crystal silicon substrate B, with a plurality of nozzle channels 111 that include nozzles N as illustrated in FIG. 3A to FIG. 3C.

### (Single-Crystal Silicon Substrate)

The single-crystal silicon substrate B is a plate-like member made of single-crystal silicon (Si) with a thickness of, for example, about 50 µm to 725 µm. The crystal orientations of the front and back surfaces of the single-crystal silicon substrate B are {110} planes. Using the single-crystal silicon substrate B as the base material of the nozzle plate 110 makes it possible to process the nozzles N with high precision in the manufacturing process. This allows the nozzles N with little positional error and shape variation to be formed.

### (Nozzle Channel)

Each of the nozzle channels 111 is a through hole that penetrates from the bonding surface Ba, which is the first surface of the single-crystal silicon substrate B, to the ejection surface Bb, which is the second surface. As illustrated in FIG. 3B and FIG. 3C, the nozzle channel 111 is provided with, for example, a nozzle N, a nozzle straight portion 1111, a nozzle tapered portion 1112, and a straight communication path 1113 from the ejection surface Bb toward the bonding surface Ba.

### < Nozzle >

The nozzle N is a cylindrical hole having a circular or polygonal cross-section in the left-right direction. The nozzles N are disposed in a matrix on the side of the ejection surface Bb of the single-crystal silicon substrate B. The side of the nozzle N that faces the bonding surface Ba communicates with the nozzle straight portion 1111. For example, when the cross-sectional shape of the nozzle N in the direction perpendicular to the ejection direction is a perfect circle, the diameter of the opening can be set to about 10 µm to 45 µm.

### < Nozzle Straight Portion >

As illustrated in FIG. 3B, the nozzle straight portion 1111 communicates with the nozzle tapered portion 1112 and is formed so as to be perpendicular to the ejection surface Bb of the single-crystal silicon substrate B.

The channel area of the nozzle straight portion 1111 is formed so as to be less than or equal to the channel area of an end portion of the nozzle tapered portion 1112 on the side facing the ejection surface Bb. Here, the channel area is the cross-sectional area with respect to the ink ejection direction. This configuration increases the resistance applied when the ink is ejected from the nozzle N. As a result, the vibration of the meniscus is suppressed, and the meniscus shape can be more stabilized.

In a case where the single-crystal silicon substrate B includes a non-wet etching layer, the non-wet etching layer may be used for an end portion of the nozzle straight portion 1111 on the side facing the bonding surface Ba.

The non-wet etching layer can be formed by performing, for example, masking, thermal oxidation processing, or high-concentration doping on the single-crystal silicon substrate B. The non-wet etching layer suppresses the progress of anisotropic wet etching in the manufacturing process of the nozzle plate 110 described later. Providing the non-wet etching layer in the single-crystal silicon substrate B thus makes it possible to predefine the length of the nozzle straight portion 1111 in the ejection direction. Therefore, the nozzle straight portion 1111 that has the non-wet etching layer for the end portion on the side facing the bonding surface Ba is a highly precise nozzle straight portion 1111.

For the single-crystal silicon substrate B that includes the non-wet etching layer, a silicon on insulator (SOI) may be used in which an oxide film is provided inside a silicon wafer and a thin silicon layer is formed thereon.

In FIG. 3B and FIG. 3C, the configuration in which the nozzle straight portion 1111 is formed continuously with the end portion of the nozzle tapered portion 1112 on the side facing the ejection surface Bb is illustrated, but the configuration is not limited thereto. However, in a case where the nozzle straight portion 1111 and the nozzle tapered portion 1112 are not continuous with each other and there exits a surface (terrace plane) substantially perpendicular to a surface constituting the nozzle straight portion 1111 at the connection between the two, there is a risk that an injection defect may occur. This is because the ink ejected from the nozzles N entrains air bubbles accumulated on the terrace plane. Therefore, it is preferable that the nozzle straight portion 1111 is formed so as to be continuous with the end portion of the nozzle tapered portion 1112 on the side facing the ejection surface Bb.

Even in a case where the nozzle straight portion 1111 and the nozzle tapered portion 1112 are continuous to each other, when the entire end portion of the nozzle tapered portion 1112 on the side facing the ejection surface Bb is not substantially continuous to the end portion of the nozzle straight portion 1111 on the side facing the bonding surface Ba, there is a risk that air bubbles may remain on a terrace ridgeline. This is because a straight line (terrace ridgeline) perpendicular to the nozzle straight portion 1111 is formed at a place where the nozzle tapered portions 1112 and 1112 intersect with each other. Therefore, it is more preferable that the nozzle straight portion 1111 is formed so as to be continuous with the entire end portion of the nozzle tapered portion 1112 on the side facing the ejection surface Bb.

### < Nozzle Tapered Portion >

The nozzle tapered portion 1112 includes two surfaces (the (-1-1-1) plane and the (-1-11) plane) whose crystal planes are {111} planes. The nozzle tapered portion 1112 has a taper at a substantially constant angle such that the channel area gradually decreases from the bonding surface Ba toward the ejection surface Bb. Providing the nozzle tapered portion 1112 in the nozzle channel 111 makes it possible to stabilize the meniscus shape and ink ejection even when the meniscus of ink has retreated to the depth of the nozzle channel 111 due to high-speed driving.

It is preferable that the nozzle straight portion 1111 and the nozzle tapered portion 1112 have less eccentricity. Specifically, as illustrated in FIG. 3B, when the two surfaces constituting the nozzle tapered portion 1112 are virtually extended, the virtual intersection line is denoted as P; the distances from the intersection line P to the farthest point or line on a ridgeline, where the outer diameter of the nozzle N intersects with the nozzle tapered portion 1112 having the two surfaces, in the directions parallel to the bonding surface Ba or the ejection surface Bb among the <110> directions are denoted as α and β; then, it is preferable that the nozzle tapered portion 1112 is formed so that the absolute value of the difference between α and β is within 0.5 µm. Here, the directions parallel to the bonding surface Ba or the ejection surface Bb are the [001] direction and the [00-1] direction when the bonding surface Ba is the (110) plane.

### < Straight Communication Path>

The straight communication path 1113 includes four surfaces (the (-111) plane, the (1-1-1) plane, the (1-1-1) plane, and the (-11-1) plane) whose crystal planes are {111} planes. The straight communication path 1113 is provided from an end portion of the nozzle tapered portion 1112 on the side facing the bonding surface Ba to the bonding surface Ba.

As illustrated in FIG. 3A, the straight communication path 1113 includes two pairs of facing surfaces that are substantially parallel to each other. The straight communication path 1113 is configured such that, among the sides where the surfaces constituting the straight communication path 1113 intersect with the bonding surface Ba, the side length of one pair of facing surfaces is longer than the side length of the other surfaces. That is, the sides where the bonding surface Ba and the surfaces constituting the straight communication path 1113 intersect can be made into in an elongated, substantially parallelogram shape. When the shape of the opening of the nozzle channel 111 on the bonding surface Ba is a substantially parallelogram shape, that is, an elongated shape, the density of the nozzles N in the nozzle plate 110 is increased compared to when the shape is a square shape.

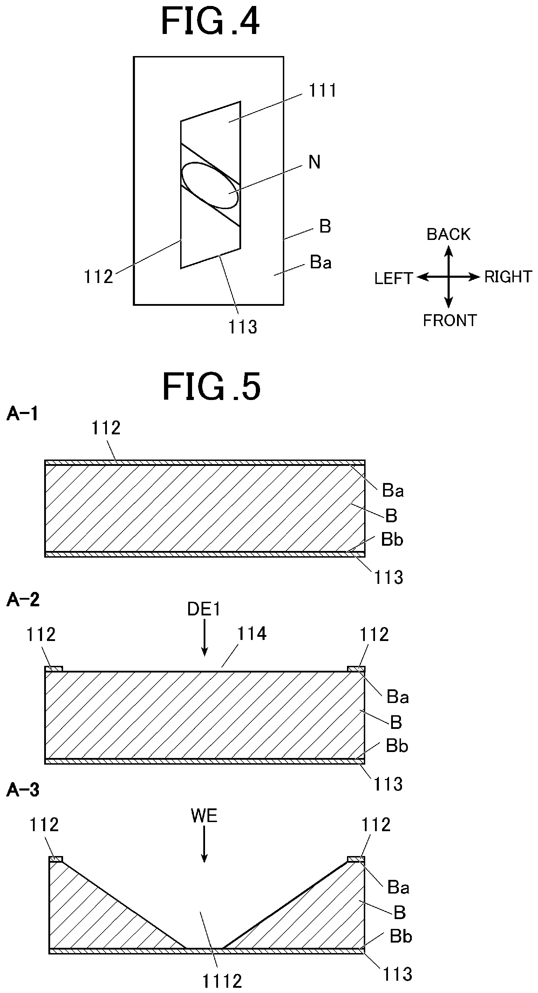

As illustrated in FIG. 4, it is preferable that the nozzle straight portion 1111 is provided such that, in a top view as viewed from the side of the bonding surface Ba, at least a portion of the ridgelines of the nozzle straight portion 1111 on the side facing the bonding surface Ba among the ridgelines thereof is substantially in contact with a surface that is substantially perpendicular to the bonding surface Ba among the surfaces constituting the straight communication path 1113. For such a nozzle channel 111, the eccentricity falls within a very small range, resulting in excellent injection stability.

In FIG. 3A to FIG. 3C, a case where all of the two surfaces constituting the nozzle tapered portion 1112 and the four surfaces constituting the straight communication path 1113 are {111} planes is exemplified, but the present invention is not limited thereto. That is, in the manufacturing process described later, the nozzle channel 111 including {111} planes and a plane of another orientation may be formed by stopping anisotropic wet etching in the middle.

In FIG. 3A to FIG. 3C, the nozzle channel 111 including the nozzle straight portion 1111, the nozzle tapered portion 1112, and the straight communication path 1113 is illustrated, but these are not essential components. It is only required that the nozzle channel 111 is at least a through hole including the nozzle N.

Furthermore, in the above description, the nozzle plate 110 that is attached to the inkjet head 10 to eject ink is exemplified. However, the liquid ejected from the nozzle plate 110 is not limited to ink.

### [Advantageous Effects of Invention]

As described above, the nozzle plate 110 according to the present embodiment includes, in the single-crystal silicon substrate B, a plurality of nozzle channels 111 that penetrates the nozzle plate 110 and ejects liquid droplets. The single-crystal silicon substrate B includes the bonding surface Ba and the ejection surface Bb that faces the bonding surface Ba. Here, the bonding surface Ba and the ejection surface Bb are on {110} planes, and the nozzles N are formed on the ejection surface Bb. This configuration allows the shape of the cross section of the nozzle channel 111 on the side facing the bonding surface Ba to be a substantially parallelogram shape, that is, an elongated shape. This makes it possible for the nozzles N to be arranged at a higher density in the nozzle plate 110 than in a case where the cross section has a square shape.

The nozzle channel 111 includes surfaces of {111} planes. According to this configuration, the nozzle channel 111 becomes a stable shape.

The nozzle channel 111 includes the nozzle tapered portion 1112 in which the channel area, which is the cross-sectional area perpendicular to the droplet ejection direction, gradually decreases from the bonding surface Ba toward the ejection surface Bb. This configuration makes it possible to stabilize the meniscus shape and the ink ejection even when the meniscus of ink has retreated to the depth of the nozzle channel 111 due to high-speed driving.

The nozzle channel 111 includes the nozzle straight portion 1111 that is provided on the side facing the ejection surface Bb of the nozzle tapered portion 1112 and has the channel area less than or equal to the channel area of the nozzle tapered portion 1112. This configuration increases the resistance during droplet ejection, suppressing the vibration of the meniscus and further stabilizing the meniscus shape, thereby improving the ejection stability.

The nozzle plate 110 includes a non-wet etching layer formed by masking, thermal oxidation, or high-concentration doping. This allows the nozzle straight portion 1111 to have the non-wet etching layer for the end portion on the side facing the bonding surface Ba. According to this configuration, the location of the nozzle straight portion 1111 is defined by the non-wet etching layer, resulting in high precision in the nozzle straight portion 1111.

The nozzle straight portion 1111 can be provided continuously with the end portion of the nozzle tapered portion 1112 on the side facing the second surface. According to this configuration, the nozzle channel 111 has no terrace plane. This prevents the ink ejected from the nozzles N from entraining air bubbles accumulated on the terrace plane, thereby preventing an injection defect.

In a top view as viewed from the side of the bonding surface Ba, among the ridgelines constituting the nozzle straight portion 1111, at least a portion of the ridgelines on the side facing the bonding surface Ba is substantially in contact with a surface substantially perpendicular to the bonding surface Ba among the surfaces constituting the nozzle tapered portion 1112 or the straight communication path 1113. The surfaces substantially perpendicular to the bonding surface Ba are, for example, the (-111) plane and the (1-1-1) plane when the bonding surface Ba is the (110) plane. According to this configuration, the nozzle channel 111 has less eccentricity in the front-rear direction in FIG. 4.

### [Method for Manufacturing Nozzle Plate]

### [First Embodiment]

Next, the method for manufacturing the nozzle plate 110 according to the first embodiment will be described with reference to FIG. 5. The method for manufacturing the nozzle plate according to the first embodiment is to manufacture the nozzle plate 110 of the droplet ejection head 10. The manufacturing method includes steps A-1 to A-3 shown in FIG. 5 to manufacture the nozzle plate 110 in which the nozzle channels 111 including at least the nozzles N are formed.

### (Step A-1)

First, in the step A-1 (first step), a front mask layer 112 and a back mask layer 113 are uniformly formed on the bonding surface (first surface) Ba and the ejection surface (second surface) Bb, respectively, of a single-crystal silicon substrate B whose surfaces have the crystal orientations of {110} planes. Here, the first surface is the (110) plane, and the second surface is the (-1-1 0) plane. Hereinafter, when the front mask layer 112 and the back mask layer 113 are not particularly distinguished from each other, the front mask layer 112 and the back mask layer 113 are collectively referred to as "mask layers."

### <Mask Layer>

For the material of the mask layers, for example, an oxide such as silicon oxide (SiO₂), metal plating with aluminum (Al), chromium (Cr), or the like, a resin, or the like can be used. However, the material of the mask layers is not particularly limited as long as the material can stop the progress of etching during the anisotropic wet etching described later and is not removed by etching.

The thickness (length in the up-down direction) of the mask layers is not particularly limited. However, the thickness of the mask layers is preferably 0.1 to 50 µm, particularly preferably 0.5 to 20 µm. This is because the etching stop effect is enhanced when the thickness of the mask layers is 0.5 µm or more, and the formation of the mask layers is facilitated when the thickness of the mask layer is 20 µm or less. However, when the mask layers are formed by the above-described thermal oxidation, the thickness is preferably set to 1 to 5 µm.

Each of the mask layers may have a single-layer structure as shown in FIG. 5 or a multi-layer structure.

### (Step A-2)

Next, in the step A-2 (second step), an opening pattern 114 that yields the openings of the nozzle channels 111 is formed in the front mask layer 112. Specifically, a resist pattern is first formed on the front mask layer 112 by a well-known photolithography technique.

### <Resist Pattern>

For the formation of the resist pattern, a positive photoresist or a negative photoresist can be used. For the positive photoresist and the negative photoresist, known materials can be used. For example, ZPN-1150-90 manufactured by Zeon Corporation can be used for the negative photoresist. For the positive photoresist, OFPR-800LB or OEBR-CAP112PM manufactured by Tokyo Ohka Kogyo Co., Ltd. can be used.

A resist layer is formed by coating to a predetermined thickness using a spin coater or the like. After that, a pre-baking process is performed under conditions of, for example, 110 °C and 90 seconds.

To improve adhesion, HMDS treatment may be performed before resist coating. The HMDS treatment refers to an organic material called hexamethyldisilazane. For example, hexamethyldisilazane manufactured by Tokyo Ohka Kogyo Co., Ltd (OAP) or the like can be used for the HMDS treatment. Similarly to the resist coating, a spin coater may be used for coating. Exposure to hexamethyldisilazane vapor is also expected to improve adhesion.

After the formation of the resist layer, the resist layer is exposed with an aligner or the like using a predetermined mask. For example, in the case of a contact aligner, the exposure is performed with an amount of light of about 50 mJ/cm². After that, the exposed portion of the resist layer is removed by immersion in a developer, thereby forming a resist pattern on the front mask layer 112. Here, the immersion in a developer means, for example, immersion in NMD-3 manufactured by Tokyo Ohka Kogyo Co., Ltd. for 60 seconds to 90 seconds.

After the formation of the resist pattern, the opening pattern 114 is formed by dry etching (DE1) the front mask layer 112 using the resist pattern as a mask. After the formation of the opening pattern 114, the resist pattern is removed.

### <Dry Etching>

A dry etching apparatus is used for the dry etching (DE1). Examples of the dry etching apparatus include a reactive ion etching (RIE) apparatus and an inductively coupled plasma (ICP) RIE etching apparatus, which is a dry etching apparatus employing an inductively coupled method as a discharge method. For the process gas, trifluoromethane (CHF₃), tetrafluoromethane (CF₄), or the like is used.

As an example, the opening pattern 114 can be formed by etching for a predetermined time using RIE 100C, which is a dry etching apparatus manufactured by SAMCO Inc., under the conditions of a CHF₃ gas flow rate of 80 sccm, a pressure of 3 Pa, and an RF power of 90 W.

The shape of the opening pattern 114 is not particularly limited. However, when anisotropic wet etching (WE) is performed to the end in the step A-3 described below, the opening formed by the sides where the four surfaces constituting each nozzle tapered portion 1112 intersect the bonding surface Ba has a substantially parallelogram shape that circumscribes the opening pattern 114. Therefore, from the viewpoint of improving the quality and production efficiency of the nozzle plate 110, it is preferable that the shape of the opening pattern 114 is also a substantially parallelogram shape following these surface orientations. The four surfaces constituting each nozzle tapered portion 1112 are the (-1-1-1) plane, the (-1-11) plane, the (-111) plane, and the (1-1-1) plane, and the bonding surface Ba is the (110) plane.

### <Removal of Resist Pattern>

As for the method of removing the resist pattern, the resist pattern can be removed by, for example, a wet process using acetone or an acid solution, or a dry process using oxygen plasma.

### (Step A-3)

Finally, in the step A-3 (third step), the anisotropic wet etching (WE) is performed on the opening pattern 114 at least from the side of the bonding surface Ba of the single-crystal silicon substrate B to form the nozzle channels 111 that include the nozzle tapered portions 1112.

### <Anisotropic Wet Etching >

For the anisotropic wet etching, an alkaline aqueous solution such as potassium hydroxide (KOH), tetramethylammonium hydroxide (TMAH), or ethylenediamine pyrocatechol (EDP) is used.

### [Advantageous Effects of Invention]

With the method of manufacturing the nozzle plate 110 according to the first embodiment of the present invention as described above, it is possible to form the nozzle channels 111 that include the nozzle tapered portions 1112 having very stable shapes formed on the {111} planes.

In addition, in the single-crystal silicon substrate B whose crystal orientation of the front surface is a {110} plane, the surface formed when the anisotropic wet etching is performed from the front surface to the end has an extremely lower etching rate than the other surfaces, and thus becomes a {111} plane on which a so-called "etching stop" occurs. This allows, in managing conditions of anisotropic wet etching in which production variations are generally likely to occur, production management to be performed with a margin enough to absorb the production variations.

In a case where the nozzle channel 111 that is a through hole is formed by performing anisotropic wet etching on the single-crystal silicon substrate B from the bonding surface Ba, the opening of the nozzle channel 111 on the side of the bonding surface Ba can be formed in an elongated, substantially parallelogram shape, that is, in an elongated shape. Here, the crystal orientation of the front surface of the single-crystal silicon substrate B is a {110} plane. This makes it possible to increase the density of the nozzles N in the nozzle plate 110.

In the step A-1, the mask layers are formed on both surfaces of the single-crystal silicon substrate B, but the present invention is not limited thereto. Specifically, for example, when anisotropic wet etching is performed by immersing the single-crystal silicon substrate B in an etching solution, it is necessary to form the back mask layer 113 on the ejection surface Bb. However, when anisotropic wet etching is performed only on the bonding surface Ba, the back mask layer 113 may not be provided.

When the back mask layer 113 is formed on the ejection surface Bb, it is, of course, necessary to remove at least the back mask layer(s) 113 covering the nozzles N after the step A-3. However, whether to remove the other back mask layer(s) 113 and/or the front mask layer(s) 112 is optional. When the mask layers are formed of, for example, SiO₂, the mask layers can be removed with hydrofluoric acid.

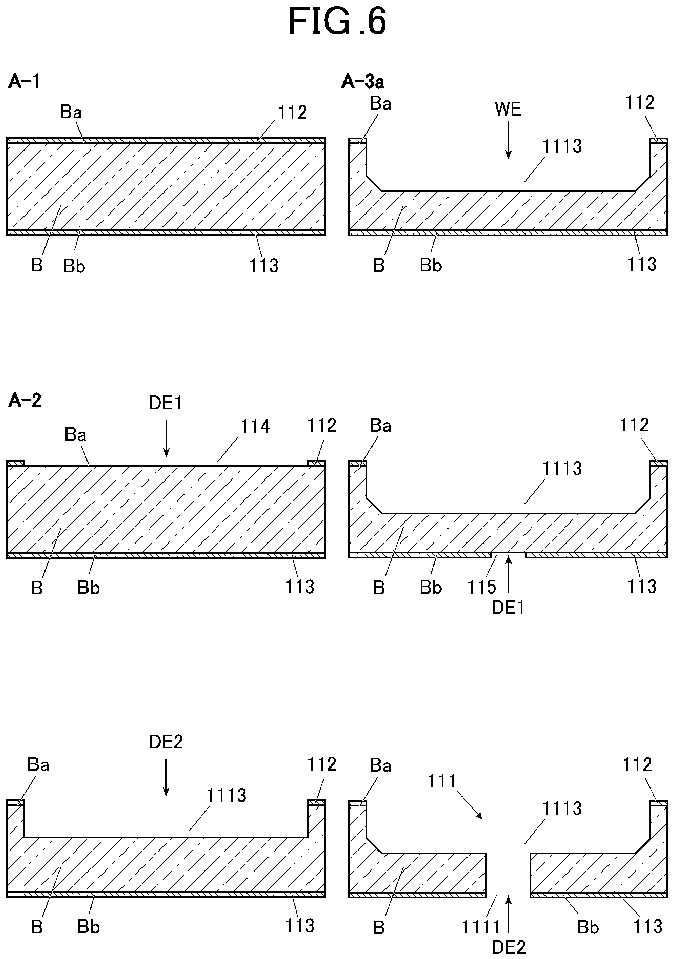

The nozzle tapered portions 1112 are formed by the anisotropic wet etching (WE) in the step A-3, but the present invention is not limited thereto. For example, as shown in FIG. 6, after the step A-2, the straight communication paths 1113 may be formed by dry etching (DE2) the single-crystal silicon substrate B through the opening pattern 114; next, in the step A-3a (third step), after the time is controlled so that the anisotropic wet etching (WE) is stopped midway, the nozzle pattern 115 that yields the nozzles N may be formed by dry etching (DE1) the ejection surface Bb; then, the single-crystal silicon substrate B with the nozzle pattern 115 may be dry etched (DE2) to provide through holes, thereby forming the nozzle channels 111. The dry etching (DE2) may be performed using an ICP-RIE etching apparatus that employs an inductively coupled method (inductively coupled plasma) as a discharge method.

The nozzle channels 111 that include the nozzle tapered portions 1112 and the straight communication paths 1113 may be provided by forming deep holes by dry etching (DE2) using a Si deep etching apparatus or the like after forming the opening pattern 114 in the step A-2, and performing anisotropic wet etching (WE) on the deep holes in the step A-3.

### [Second Embodiment]

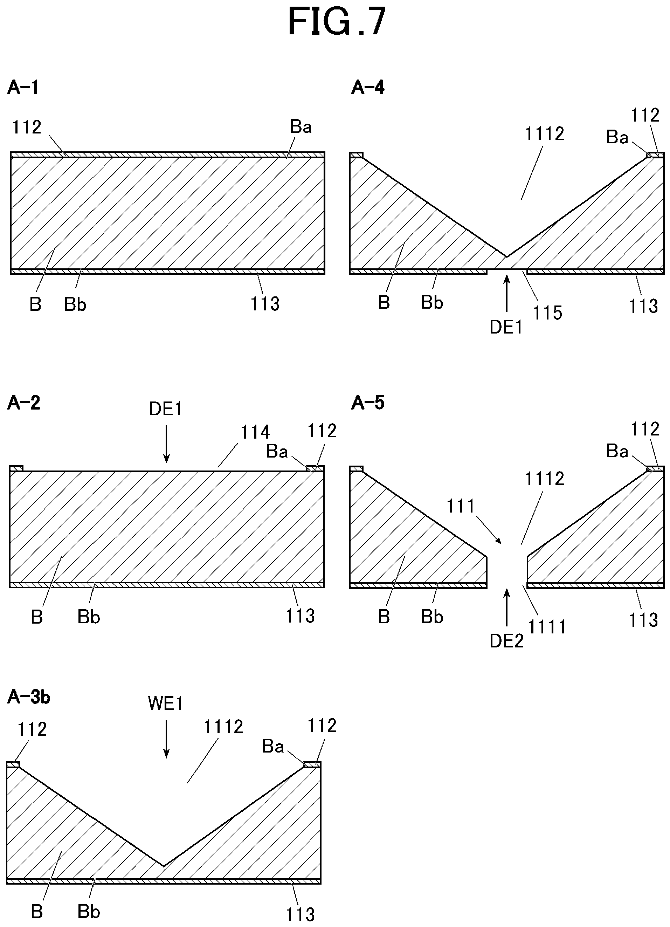

Next, the method for manufacturing the nozzle plate 110 according to the second embodiment will be described with reference to FIG. 7. In the method of manufacturing the nozzle plate 110 according to the second embodiment, steps A-3b to A-5 are performed after the step A-2 of the method of manufacturing the nozzle plate 110 according to the first embodiment. Therefore, the detailed description of the steps A-1 and A-2 is omitted.

### (Step A-4)

After deep holes are formed by performing anisotropic wet etching (WE) in the step A-3b (third step), the nozzle pattern 115 that yields the nozzles N is formed in the back mask layer 113 in the step A-4 (fourth step).

Specifically, in the step A-3b according to the second embodiment, the anisotropic wet etching (WE) is performed until the etching stops on the surfaces constituting each nozzle tapered portion 1112, which are {111} planes formed by the anisotropic wet etching (WE). The method of forming the nozzle pattern 115 in the step A-4 is the same as the method of forming the opening pattern 114 in the step A-2.

### (Step A-5)

In the step A-5 (fifth step), dry etching (DE2) is performed on the nozzle pattern 115 provided in the step A-4. Then, the holes that yield the nozzle straight portions 1111 are made to communicate with the nozzle tapered portions 1112 provided in the step A-3b to form the nozzle channels 111 that include the nozzle straight portions 1111 and the nozzle tapered portions 1112.

### [Advantageous Effects of Invention]

According to the method of manufacturing the nozzle plate 110 according to the second embodiment of the present invention as described above, it is possible to form the nozzle channels 111 that include the nozzle straight portions 1111 and the nozzle tapered portions 1112 having very stable shapes formed on {111} planes.

The etching may be stopped in the step A-3b by providing the single-crystal silicon substrate B with a non-wet etching layer. In order to obtain the single-crystal silicon substrate B provided with a non-wet etching layer, masking, thermal oxidation processing, high concentration doping, or the like is performed on the single-crystal silicon substrate B, or SOI is used for the single-crystal silicon substrate B. This allows the heights of the nozzle straight portions 1111 formed in the step A-5 to be uniquely determined, making it possible to form the nozzle straight portions 1111 with higher precision.

When the single-crystal silicon substrate B that includes a non-wet etching layer is used for the nozzle plate 110, anisotropic wet etching (WE) may be performed from both the bonding surface Ba and the ejection surface Bb. Specifically, after the step A-2, deep etching is performed by dry etching (DE2); then, the steps A-4 and A-5 are performed; and after the step A-5, as the step A-3b, anisotropic wet etching (WE) is performed from both the bonding surface Ba and the ejection surface Bb. This makes it possible to form the nozzle channels 111 that include the nozzle straight portions 1111 in the non-wet etching layers, and the straight communication paths 1113 and nozzle tapered portions 1112.

### [Third Embodiment]

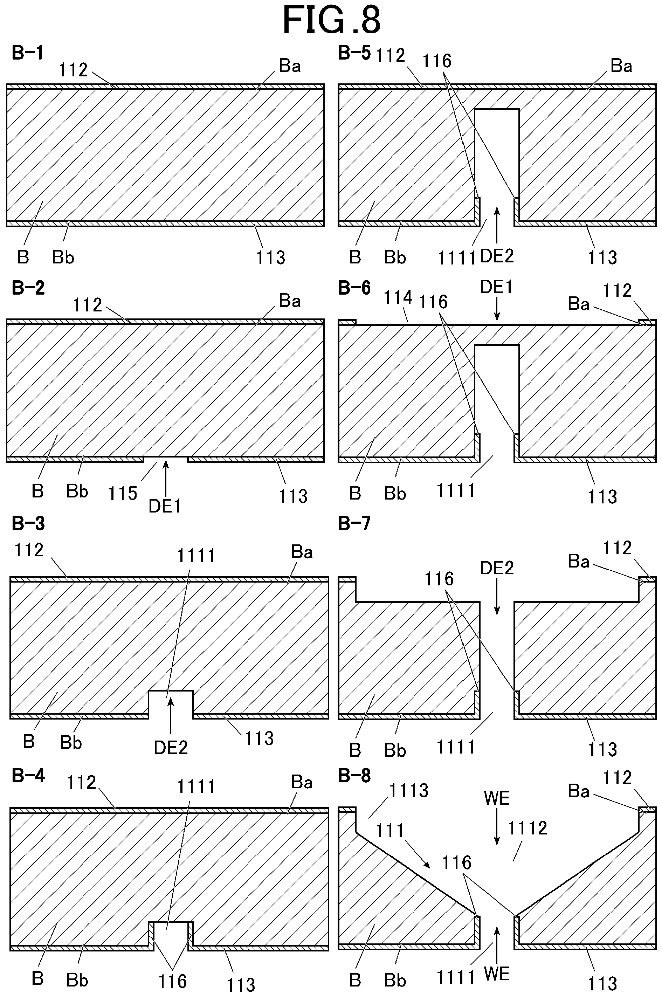

Next, the method for manufacturing the nozzle plate according to the third embodiment of the present invention and the nozzle plate manufactured by the method will be described with reference to FIG. 8. The method of manufacturing the nozzle plate 110 according to the third embodiment includes steps B-1 to B-8 shown in FIG. 8. In the following description, the detailed description of the content that overlaps with the steps of manufacturing the nozzle plate according to the first embodiment and the second embodiment is omitted.

### (Step B-1, Step B-2)

First, in the step B-1 (first step), the front mask layer 112 and the back mask layer 113 are uniformly formed on the bonding surface Ba (the (110) plane) and the ejection surface Bb (the (-1-10) plane), respectively, of the single-crystal silicon substrate B whose surfaces have the crystal orientation of {110} planes. In the step B-2 (second step), the nozzle pattern 115 that yields the nozzles N is formed in the back mask layer 113.

### (Step B-3)

In the step B-3 (third step), each of the nozzle straight portions 1111 is formed by dry etching (DE2) the single crystal silicon substrate B through the nozzle pattern 115 by a predetermined length of the nozzle straight portion 1111.

### (Step B-4)

In the step B-4 (fourth step), nozzle mask layers 116 are formed along the inner surfaces of the nozzle straight portion 1111. The material and the formation method of the nozzle mask layers 116 are the same as the material and the formation method of the mask layers in the Step A-1.

After that, the nozzle mask layer 116 formed at the bottom of the nozzle straight portion 1111 is removed. The nozzle mask layer 116 at the bottom of the nozzle straight portion 1111 can be removed by dry etching using an RIE apparatus or the like. However, dry etching using the RIE apparatus is difficult to remove the nozzle mask layers 116 formed on the side surfaces compared to the nozzle mask layer 116 formed at the bottom, due to the verticality of an etchant. Therefore, the nozzle mask layer 116 at the bottom is etched first while the nozzle mask layers 116 remain on the side surfaces.

The dry etching conditions in the step B-4 may be set to a low pressure or a high bias so that the nozzle mask layers 116 on the side surfaces are less likely to be etched.

### (Step B-5)

In the step B-5 (fifth step), each of the nozzle straight portions 1111 is further deep-etched by dry etching (DE2).

### (Step B-6, Step B-7)

In the step B-6 (sixth step), the opening pattern 114 that yields the openings of the nozzle channels 111 is formed in the front mask layer 112. In the step B-7 (seventh step), holes that yield the straight communication paths 1113 are provided by dry etching (DE2) the single-crystal silicon substrate B through the opening pattern 114.

In the step B-7, as illustrated in FIG. 8, it is preferable that dry etching (DE2) is performed until all the nozzle channels 111 communicate with the holes provided in the step B-5 to penetrate the single-crystal silicon substrate B. In the case where the through holes are provided in the step B-7, hydrogen gas, which is generated when anisotropic wet etching (WE) is performed in the step B-8 (eighth step) described later, is uniformly and efficiently released, resulting in uniform etching progress. As a result, shape variation is less likely to occur in the nozzle channels 111. However, it is not essential to penetrate the single-crystal silicon substrate B in the step B-7. In a case where the single-crystal silicon substrate B is not penetrated in the step B-7, it is possible, by digging up to just before penetration, to shorten the time for penetration by wet etching in the wet etching process of the step B-8.

### (Step B-8)

In the step B-8, anisotropic wet etching (WE) is performed from both sides of the bonding surface Ba and the ejection surface Bb to enlarge the holes provided in the step B-5 and the holes provided in the step B-7, thereby forming the nozzle tapered portions 1112. In this step, since the nozzle straight portions 1111 are protected by the nozzle mask layers 116, the progress of etching is suppressed and the nozzle straight portions 106 remain.

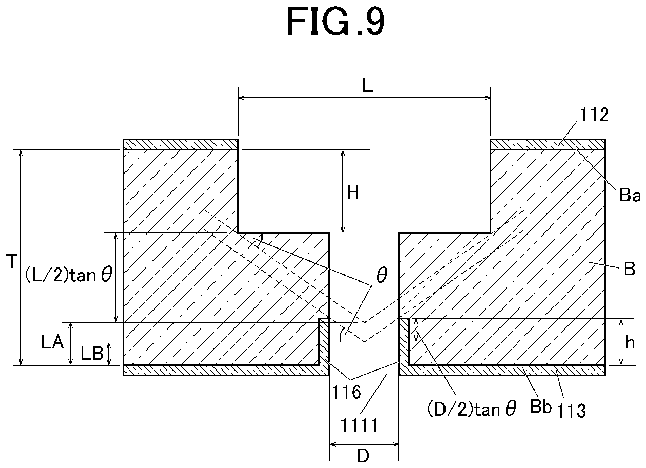

As shown in FIG. 9, the depth H of each of the holes formed in the step B-7 of the method of manufacturing the nozzle plate 110 according to the third embodiment satisfies the following: T-(H + (L/2) tan θ) ≥ h-(D/2) tan θ. In this equation, T is the thickness of the single-crystal silicon substrate B when the bonding surface Ba is the (110) plane and the ejection surface Bb is the (-1-10) plane; D is the width of each of the nozzle straight portions 1111 in the [001] direction and the [001] direction; H is the depth (length in the ejection direction) of each of the nozzle straight portions 1111. L is the width of the opening pattern 114 in the [001] direction and the [00-1] direction. θ is the angle between the (-1-10) plane and the (-1-1-1) plane of the single-crystal silicon substrate B, i.e., θ = cos⁻¹ (2/√6) ≈ 35.26 degrees. In FIG. 9, the left hand side of the equation, T-(H + (L/2) tan θ), and the right hand side of the equation, h-(D/2) tan θ, are illustrated as LA and LB, respectively.

### [Advantageous Effects of Invention]

According to the method of manufacturing the nozzle plate 110 according to the third embodiment as described above, the nozzle mask layers 116 formed in the nozzle channels 111 suppress the progress of etching during anisotropic wet etching (WE). This makes it possible to form, in each of the nozzle channels 111, the nozzle straight portion 1111 having a desired length.

In the step B-8, the etching progresses from both the end portion of each nozzle straight portion 1111 on the side facing the bonding surface Ba and the end portion of each hole provided in the step B-7 on the side facing ejection surface Bb. However, by setting the depth H of each hole formed in the step B-7 so as to satisfy the above equation, the two tapered surfaces of each nozzle tapered portion 1112 to be finally formed are always formed continuously from the side facing the bonding surface Ba of each nozzle straight portion 1111. This makes it possible to manufacture the nozzle straight portion 1111 and the nozzle tapered portion 1112 without misregistration. This allows for the nozzle channel 111 in which the eccentricity is small, the symmetry of the ink flow is maintained, and the ejection angle is stable.

In the nozzle channels 111 in their final form, etching is stopped on {111} planes that circumscribe the holes formed in the step B-7 and the ridgelines of the nozzle straight portions 1111 on the side facing the bonding surface Ba. This prevents misregistration or step difference between the nozzle tapered portions 1112 and the straight communication paths 1113, resulting in stable nozzle channels 111.

In the dry etching process, precise control is difficult due to dry etching conditions such as concentration distribution of an etchant and voltage distribution, and a manufacturing error is likely to occur. However, as long as the above equation is satisfied, the surfaces constituting each nozzle tapered portion 1112 formed in the step B-8 are formed continuously from the end portions of the surfaces constituting each nozzle straight portion 1111 on the side facing the bonding surface Ba. This makes it possible to set the depth H of each hole formed in the step B-7 to be slightly negative with a margin from the final, desired depth of each straight communication path 1113, thereby reducing the manufacturing error caused in this process. This allows for manufacturing the nozzle plate 110 with stable ejection characteristics.

It is preferable that the widths of the nozzle pattern 115 in the [-111] direction and the [1-1-1] direction are wider than the widths of the opening pattern 114 in the [-111] direction and the [1-1-1] direction. Here, the nozzle pattern 115 is formed in the step B-2 and the opening pattern 114 is formed in the step B-6.

In a case where this configuration is satisfied, when the anisotropic wet etching is performed to the end in the step B-8, the four surfaces constituting each straight communication path 1113 eventually reach {111} planes (the (-111) plane, the (1-1-1) plane, the (1-11) plane, and the (-11-1) plane) that circumscribe the outermost diameter of the opening pattern 114 or the nozzle pattern 115. As a result, at least a portion of the ridgelines on the side facing the bonding surface Ba of the surfaces constituting each nozzle straight portion 1111 substantially comes in contact with the (-111) plane and the (1-1-1) plane among the surfaces constituting each straight communication path 1113. This makes it possible to provide the nozzle channels 111 with less eccentricity in the [-111] direction and the [1-1-1] direction.

In the above description, the steps B-6 and B-7 in which the holes that yield the straight communication paths 1113 are provided from the bonding surface Ba are performed after the steps B-3 to B-5 in which the nozzle straight portions 1111 are provided from the ejection surface Bb, but the present invention is not limited thereto. That is, the holes that yield the straight communication paths 1113 may be provided before the nozzle straight portions 1111.

After the step B-8, removal processing may be performed on the bonding surface Ba of the single-crystal silicon substrate B by etching, grinding, or polishing so that the thickness of the nozzle plate 110 and the depth of each straight communication path 1113 are adjusted to desired dimensions. A process of removing the mask layers including the nozzle mask layers 116 may be performed.

In the manufacturing method according to each embodiment, at least one protective film may be formed in order to use the nozzle plate 110 for a long period of time. In this case, a step of forming a protective film that covers at least a portion of the surfaces including the inside of the nozzle channel 111 is performed after the final step of each embodiment.

For the protective film, a material that does not dissolve upon contact with the ink is used. The protective film includes, for example, a metal oxide film such as tantalum pentoxide, hafnium oxide, niobium oxide, titanium oxide, and zirconium oxide. Alternatively, the protective film may be a metal silicate film containing silicon in a metal oxide film such as tantalum silicate, hafnium silicate, niobium silicate, titanium silicate, or zirconium silicate. Furthermore, for the protective film, a silicon carbide (SiC) film, a diamond-like carbon (DLC) film, or the material used for forming the mask layers may be used. For the protective film, an organic film such as polyimide, polyamide, or parylene may also be used. The thickness of the protective film is not particularly limited, but may be set to, for example, 0.05 µm to 20 µm.

### Examples

Next, with respect to Examples and Comparative Examples of the present invention, the results of evaluating preferred configurations will be described. Hereinafter, the present invention will be specifically described with reference to Examples, but the present invention is not limited thereto.

### [Sample Preparation]

The nozzle plate 110 having 1280 nozzle channels 111 formed as in each of the following Examples and Comparative Examples was manufactured. Next, the piezoelectric material plate 120 and the nozzle plate 110 were bonded to form the inkjet head 10. In the piezoelectric material plate 120, the cross-sectional shape of the ink channel in the left-right direction is the same as the cross-sectional shape of the bonding surface Ba of the nozzle plate 110 in the left-right direction. Then, the inkjet heads 10 were mounted on the inkjet recording apparatus 1.

### (Example 1)

The nozzle channels 111 were formed by the following steps A-1 to A-3. Step A-1: The front mask layer 112 and the back mask layer 113, each with the thickness of 1 µm, were formed by thermal oxidation on the single-crystal silicon substrate B with the thickness of 50 µm whose surfaces have the crystal orientations of the (110) plane and the (-1-10) plane. Step A-2: Using a positive photoresist, a substantially parallelogram pattern was formed on the front mask layer 112. The substantially parallelogram pattern has the base of 130 µm, the height of 50 µm, and the angles between the sides matching the angles between the (-111) plane, (1-1-1) plane, (1-11) plane, and (-11-1) plane. Next, dry etching (DE1) was performed using an RIE apparatus to form the opening pattern 114. For the etching gas, CHF₃ gas was used. After the dry etching, the photoresist was removed by immersion in acetone. Step A-3: Anisotropic wet etching (WE) was performed by immersion in a 40 wt% KOH solution at 80 °C for 35 minutes to form the nozzle tapered portions 1112 having {111} planes. The mask layers were removed with hydrofluoric acid after the step A-3.

### (Example 2)

The nozzle channels 111 were formed by the following steps A-1 to A-5. Step A-1: The front mask layer 112 and the back mask layer 113, each with the thickness of 1 µm, were formed by thermal oxidation on the single-crystal silicon substrate B with the thickness of 83 µm whose surfaces have the crystal orientations of the (110) plane and the (-1-10) plane. Step A-2: Using a positive photoresist, a substantially parallelogram pattern was formed on the front mask layer 112. The substantially parallelogram pattern has the base of 130 µm, the height of 50 µm, and the angles between the sides matching the angles between the (-111) plane, (1-1-1) plane, (1-11) plane, and (-11-1) plane. Next, dry etching (DE1) was performed using an RIE apparatus to form the opening pattern 114. Step A-3: Anisotropic wet etching (WE) was performed for 35 minutes under the same conditions as in Example 1 to form the nozzle tapered portions 1112 having {111} planes. Step A-4: Using the RIE apparatus, the pattern formed on the back mask layer 113 was dry etched (DE1) to form the nozzle pattern 115 having a perfectly circular shape with the diameter φ of 30µm. For the etching gas, CHF₃ gas was used. Step A-5: Using a Si deep etching apparatus, the single-crystal silicon substrate B with the nozzle pattern 115 was dry etched (DE2) by the Bosch process to communicate with the nozzle tapered portions 1112 provided in the step A-3. As a result, the nozzle straight portions 1111 each having the depth of 40.6 µm were formed. For the etching gas, SF₆ and C₄F₈ gases were used. The mask layers were removed with hydrofluoric acid after the step A-5.

### (Example 3)

The nozzle channels 111 were formed by the following steps A-1 to A-5. Step A-1: A thick SiO₂ film with the thickness of 10 µm was formed by thermal oxidation as a non-wet etching layer on the ejection surface Bb of the single-crystal silicon substrate B, whose surfaces have the crystal orientations of the (110) plane and the (-1-10) plane. The total thickness was set to 50 µm. The front mask layer 112 having the thickness of 1 µm was formed on the bonding surface Ba by thermal oxidation. The back mask layer 113 was formed on the non-wet etching layer of the ejection surface Bb by using a positive photoresist. Step A-2: Using a positive photoresist, a substantially parallelogram pattern was formed on the front mask layer 112. The substantially parallelogram pattern has the base of 130 µm, the height of 50 µm, and the angles between the sides matching the angles between the (-111) plane, (1-1-1) plane, (1-11) plane, and (-11-1) plane. Next, dry etching (DE1) was performed using an RIE apparatus to form the opening pattern 114. Step A-3: Anisotropic wet etching (WE) was performed for 35 minutes under the same conditions as in Example 1 to form the nozzle tapered portions 1112 having {111} planes. Step A-4: Using the RIE apparatus, the pattern formed on the back mask layer 113 was dry etched (DE1) to form the nozzle pattern 115 having a perfectly circular shape with the diameter φ of 30 µm. Step A-5: Dry etching (DE2) was performed using the RIE apparatus to form the nozzle straight portions 1111 having the depth of 10 µm.

### (Example 4)

The nozzle channels 111 were formed by the following steps A-1 to A-5. Step A-1: A thick SiO₂ film with the thickness of 10 µm was formed by thermal oxidation as a non-wet etching layer on the ejection surface Bb of the single-crystal silicon substrate B, whose surfaces have the crystal orientations of the (110) plane and the (-1-10) plane. The total thickness was set to 50 µm. The front mask layer 112 having the thickness of 1 µm was formed on the bonding surface Ba by thermal oxidation. The back mask layer 113 was formed on the non-wet etching layer of the ejection surface Bb by using a positive photoresist. Step A-2: Using a positive photoresist, a substantially parallelogram pattern was formed on the front mask layer 112. The substantially parallelogram pattern has the base of 130 µm and the height of 15 µm, which is narrower than the diameter φ of 30 µm of the nozzle pattern 115 to be formed in the subsequent step A-4, and the angles between the sides matching the angles between the (-111) plane, (1-1-1) plane, (1-11) plane, and (-11-1) plane. After that, the steps A-4 and A-5 were performed to form through holes. A-3 process: Anisotropic wet etching (WE) was performed for 35 minutes on the through holes provided in the A-2 step. As a result, the nozzle channels 111 were formed in which the ridgeline of each nozzle straight portion 1111 on the side facing the bonding surface Ba was substantially in contact with the end portions of the two tapered surfaces of each nozzle tapered portion 1112 on the side facing the ejection surface Bb and the two surfaces of each nozzle tapered portion 1112 perpendicular to the bonding surface Ba. Here, each nozzle tapered portion 1112 was formed on {111} planes.

### (Example 5)

SOI was used for the single-crystal silicon substrate B. After the single-crystal silicon substrate B was deep-etched in the step A-5, the SiO₂ layer (Box layer) was etched using an RIE apparatus to form through holes. The other conditions were the same as in Example 2.

### (Example 6)

The nozzle channels 111 were formed by the following steps A-1 to A-3. Step A-1: The front mask layer 112 and the back mask layer 113, each with the thickness of 1 µm, were formed by thermal oxidation on the single-crystal silicon substrate B with the thickness of 100 µm whose surfaces have the crystal orientations of the (110) plane and the (-1-10) plane. Step A-2: Using a positive photoresist, a substantially parallelogram pattern was formed on the front mask layer 112. The substantially parallelogram pattern has the base of 130 µm, the height of 50 µm, and the angles between the sides matching the angles between the (-111) plane, (1-1-1) plane, (1-11) plane, and (-11-1) plane. Next, dry etching (DE1) was performed using an RIE apparatus to form the opening pattern 114. After that, using a Si deep etching apparatus, the single-crystal silicon substrate B with the opening pattern 114 was dry etched (DE2) by the Bosch process to form holes each having the depth of 51 µm. Step a-3: After anisotropic wet etching (WE) was performed for 35 minutes on the holes provided after the step A-2, the mask layers were removed with hydrofluoric acid to form the nozzle channels 111 that include the straight communication paths 1113 and the nozzle tapered portions 1112.

### (Example 7)

The nozzle channels 111 were formed by the following steps B-1 to B-8. Step B-1: The front mask layer 112 and the back mask layer 113, each with the thickness of 3 µm, were formed by thermal oxidation on the single-crystal silicon substrate B with the thickness of 200 µm whose surfaces have the crystal orientations of {110} planes. Step B-2: Using the RIE apparatus, the pattern formed on the back mask layer 113 was dry etched (DE1) to form the nozzle pattern 115 having a perfectly circular shape with the diameter φ of 30µm. For the etching gas, CHF₃ was used. Step B-3: Using a Si deep etching apparatus, the single-crystal silicon substrate B with the nozzle pattern 115 was dry etched (DE2) by the Bosch process. As a result, the nozzle straight portions 1111 each having the depth of 40.6 µm were formed. For the etching gas, SF₆ and C₄F₈ gases were used. Step B-4: The mask layers having the thickness of 1 µm were formed in the nozzle straight portions 1111 by thermal oxidation. Then, the mask layers only at the bottom were removed by an RIE apparatus to form the nozzle mask layers 116. Step B-5: Dry etching (DE2) by the Bosch process was performed using the Si deep etching apparatus to form the nozzle straight portions 1111 of deep holes each having the depth of 120 µm. Step B-6: Using a positive photoresist, a substantially parallelogram pattern was formed on the front mask layer 112. The substantially parallelogram pattern is set to 130 µm × 50 µm and has the angles between the sides matching the angles between the (-111) plane, (1-1-1) plane, (1-11) plane, and (-11-1) plane. Then, dry etching (DE1) was performed using an RIE apparatus to form the opening pattern 114. After the dry etching (DE1), the photoresist was removed by immersion in acetone. Step B-7: Using the Si deep etching apparatus, the single-crystal silicon substrate B with the opening pattern 114 was dry etched (DE2). As a result, holes each having the depth of 100 µm were formed so as to communicate with the deep holes formed in the step B-5. In this case, the thickness (T) of the single-crystal silicon substrate B is 200 µm, the diameter (D) of each nozzle straight portion 1111 is 30 µm, the depth (h) of each nozzle straight portion 1111 is 40.6 µm, the width (L) of the opening pattern 114 in the {110} direction is 149.45 µm, and the depth (H) of each hole formed in the step B-7 is 100 µm. Therefore, $t - \left(H+\left(L/2\right) tan θ\right) \approx 47.17$

From h-(D/2) tan θ ≈ 29.99
t-(H + (L/2) tan θ) ≥ h-(D/2) tan θ is satisfied. Step B-8: Anisotropic wet etching (WE) was performed by immersion in a 40 wt KOH solution at 80 °C for 80 minutes to form the nozzle channels 111 that include the nozzle straight portions 1111, the nozzle tapered portions 1112, and the straight communication paths 1113. The mask layers were removed with hydrofluoric acid after the step B-8.

### (Example 8)

In the step B-1, a thick SiO₂ film with the thickness of 10 µm was formed by thermal oxidation as a non-wet etching layer on the ejection surface Bb. Then, the back mask layer 113 was formed. The other conditions were the same as in Example 7.

### (Example 9)

The nozzle pattern 115 provided in the step B-2 was formed in an elliptical shape having the major axis of 60.3 µm and the minor axis of 14.9 µm. The other conditions were the same as in Example 8.

### (Example 10)

For the single-crystal silicon substrate B, SOI was used. The other conditions were the same as in Example 7.

### (Example 11)

The nozzle pattern 115 provided in the step B-2 was formed in an elliptical shape having the major axis of 60.3 µm and the minor axis of 14.9 µm. Furthermore, the opening pattern 114 provided in the step B-6 was set to 130µm × 35µm. The other conditions were the same as in Example 7. In this case, the thickness (T) of the single-crystal silicon substrate B is 200 µm, the width (D) of each nozzle straight portion 1111 is 14.9 µm, the depth (h) of each nozzle straight portion 1111 is 35.3µm, the width (L) of the opening pattern 114 in the {110} direction is 149.45 µm, and the depth (H) of each hole formed in the step B-7 is 100 µm. Therefore, $t - \left(H+\left(L/2\right) tan θ\right) \approx 47.12$

From h-(D/2) tan θ ≈ 30.03
t-(H + (L/2) tan θ) ≥ h-(D/2) tan θ is satisfied.

### (Comparative Example 1)

Anisotropic wet etching (WE) was performed on the single-crystal silicon substrate B with the thickness of 200 µm whose surfaces have the crystal orientations of {100} planes. As a result, the nozzle channels 111 were formed such that the shape of each cross section in the left-right direction on the bonding surface Ba was a square shape of 130 µm × 130 µm.

### (Comparative Example 2)

Anisotropic wet etching (WE) was performed on the single-crystal silicon substrate B with the thickness of 200 µm whose surfaces have the crystal orientations of {100} planes. As a result, the nozzle channels 111 were formed such that the shape of each cross section in the left-right direction on the bonding surface Ba was a square shape of 50 µm × 50 µm.

The following Tests 1 and 2 were performed using the inkjet recording apparatus 1 on which the inkjet heads 10 that include the nozzle plates 110 of Examples 1 to 13 and Comparative Examples 1 and 2 described above were mounted.

### [Test 1. Injection Angle Test]

The UV ink heated to a viscosity of 8 mPa.s was ejected at a drive voltage at which the average droplet speed was about 6 m/s. Then, it was evaluated to see within plus or minus how many degrees the injection angles of the 1280 nozzles lie.

### [Test 2. Maximum Speed Test]

At a drive frequency of 40kHz, the ejection speed of the UV ink heated to a viscosity of 8cP was increased from 5 m/s. Then, an injection speed at which the number of nozzles N in which ejection failure had occurred was 5 or more out of 100 nozzles was measured. In a case where the injection speed was 9 m/s or more, it was evaluated as "○ (good)" because injection failure is less likely to occur even when the injection speed is high, that is, the meniscus stability is excellent. In a case where the injection speed was 11 m/s or more, it was evaluated as "⊚ (very good)" because the meniscus stability is particularly excellent.

The results of Tests 1 and 2 are shown in Table I.

### [Table 1]

**TABLE 1**

| | | EXAMPLE 1 | EXAMPLE 2 | EXAMPLE 3 | EXAMPLE 4 | EXAMPLE 5 | EXAMPLE 6 | EXAMPLE 7 |
|---|---|---|---|---|---|---|---|---|
| STRUCTURE | CRYSTAL ORIENTATION OF WAFER SURFACE | 110 | 110 | 110 | 110 | 110 | 110 | 110 |
| | NOZZLE STRAIGHT PORTION | NO | YES | YES | YES | YES | NO | YES |
| | NON-WET ETCHING LAYER | NO | NO | YES | YES | NO | NO | NO |
| | SOI WAFER | NO | NO | NO | NO | YES | NO | NO |
| | STRAIGHT COMMUNICATION PATH | NO | NO | NO | NO | NO | YES | YES |
| | TERRACE PLANE | NO | NO | YES | YES (MINUSCULE) | YES | NO | NO |
| | TERRACE RIDGELINE | NO | YES | - | - | - | NO | YES |
| | NOZZLE PLATE HOLE SIZE (*µ*m) | 50 x 130 | 50 x 130 | 50 x 130 | 50 x 130 | 50 x 130 | 50x 130 | 50 x 130 |
| | PIEZOELECTRIC MATERIAL PLATE HOLE SIZE (*µ*m) | 50 x 130 | 50 x 130 | 50 x 130 | 50 x 130 | 50 x 130 | 50 x 130 | 50 x 130 |
| | NOZZLE DENSITY (dpi) | 360 | 360 | 360 | 360 | 360 | 360 | 360 |
| EVALUATION | EJECTION ANGLE (±° ) | 1.0 | 0.2 | 0.2 | 0.2 | 0.2 | 1.0 | 0.2 |
| | MENISCUS STABILITY | ⊚ | ○ | ○ | ⊚ | ○ | ⊚ | ○ |

**TABLE 1 Continued**

| | | EXAMPLE 8 | EXAMPLE 9 | EXAMPLE 10 | EXAMPLE 11 | COMPARATIVE EXAMPLE 1 | COMPARATIVE EXAMPLE 2 |
|---|---|---|---|---|---|---|---|
| STRUCTURE | CRYSTAL ORIENTATION OF WAFER SURFACE | 110 | 110 | 110 | 110 | 100 | 100 |
| | NOZZLE STRAIGHT PORTION | YES | YES | YES | YES | YES | YES |
| | NON-WET ETCHING LAYER | YES | YES | NO | NO | NO | NO |
| | SOI WAFER | NO | NO | YES | NO | NO | NO |
| | STRAIGHT COMMUNICATION PATH | YES | YES | YES | YES | NO | NO |
| | TERRACE PLANE | YES | YES (MINUSCULE) | YES | NO | NO | NO |
| | TERRACE RIDGELINE | - | - | - | YES (MINUSCULE) | YES | YES |
| | NOZZLE PLATE HOLE SIZE (*µ*m) | 50 x 130 | 50 x 130 | 50 x 130 | 50 x 130 | 130 x 130 | 50 x 50 |
| | PIEZOELECTRIC MATERIAL PLATE HOLE SIZE (*µ*m) | 50 x 130 | 50 x 130 | 50 x 130 | 50 x 130 | 130 x 130 | 50 x 50 |
| | NOZZLE DENSITY (dpi) | 360 | 360 | 360 | 360 | 180 | 360 |
| EVALUATION | EJECTION ANGLE (±° ) | 0.2 | 0.2 | 0.2 | 0.2 | 0.2 | - |
| | MENISCUS STABILITY | ○ | ⊚ | ○ | ⊚ | ○ | - |

In Comparative Example 2, since the hole size was too small as 50 µm × 50 µm, the ink could not be ejected even when the drive voltage was increased to 30 V

### [Evaluation]

When Examples 1 to 11 are compared with Comparative Examples 1 and 2, in a case where the nozzle channels 111 are formed in the single-crystal silicon substrate B whose surfaces have the crystal orientations of {100} planes, the openings on the side of the bonding surface Ba can be formed only in a square shape. Therefore, it is only possible to manufacture either a nozzle plate with excellent injection characteristics but low nozzle density, or a nozzle plate with excellent nozzle density but low injection characteristics. On the other hand, in a case where the nozzle channels 111 are formed in the single-crystal silicon substrate B whose surfaces have the crystal orientations of {110} planes, the openings on the side of the bonding surface Ba can be formed in an elongated shape of 50 µm × 130 µm. Therefore, it becomes possible to achieve both the high density of the nozzles N and the improvement of injection characteristics.

In particular, when Examples 1 and 6 are compared with other Examples, it is found that forming the nozzle straight portions 1111 in the nozzle channels 111 improves the injection angle and enhances the injection characteristics.

In addition, when Examples 1, 4, 6, 9, and 11 are compared with other Examples, it is found that not providing a terrace plane and a terrace ridgeline in each nozzle channel 111 or making the terrace plane and the terrace ridgeline minuscule enhances the meniscus stability, thereby providing the nozzle plate 110 in which ejection failure is less likely to occur.

### Industrial Applicability

The present invention can be used for a nozzle plate, a droplet ejection head, a droplet ejecting apparatus, and a method for manufacturing a nozzle plate, which can achieve both high density of nozzles and preferable ejection characteristics.

Note that the present technology can also be implemented as described below:
(1) A nozzle plate made of a single-crystal silicon substrate, comprising
   A plurality of nozzle channels that penetrates the nozzle plate, the plurality of nozzle channels each including a nozzle and each capable of ejecting droplets from the nozzle,
   Wherein
   The single-crystal silicon substrate includes a first surface and a second surface opposite the first surface,
   The nozzle is formed on the second surface, and
   The first surface and the second surface are {110} planes.
(2) The nozzle plate according to (1), wherein each of the plurality of nozzle channels includes a surface on a {111} plane.
(3) The nozzle plate according to (1) or (2),
   Wherein
   Each of the plurality of nozzle channels includes a nozzle tapered portion having a channel area that gradually decreases from the first surface toward the second surface, the channel area being a cross-sectional area perpendicular to a droplet ejection direction, and
   The nozzle tapered portion includes a {111} plane.
(4) The nozzle plate according to (3), wherein the nozzle tapered portion is composed of {111} planes.
(5) The nozzle plate according to (3) or (4)
   Wherein
   Each of the plurality of nozzle channels includes a nozzle straight portion on a side of the nozzle tapered portion facing the second surface, and
   A channel area of the nozzle straight portion is less than or equal to the channel area of the nozzle tapered portion.
(6) The nozzle plate according to (5), further comprising
   A non-wet etching layer formed by masking, thermal oxidation, or high-concentration doping,
   Wherein
   The nozzle straight portion has the non-wet etching layer for an end portion on a side facing the first surface.
(7) The nozzle plate according to (5) or (6), wherein the nozzle straight portion is continuous with an end portion of the nozzle tapered portion on the side facing the second surface.
(8) The nozzle plate according to any one of (5) to (7), wherein in a view from the first surface, at least a portion of a ridgeline on a side facing the first surface among ridgelines constituting the nozzle straight portion is substantially in contact with a surface substantially perpendicular to the first surface among surfaces constituting the nozzle tapered portion.
(9) The nozzle plate according to (1) or (2),
   Wherein
   Each of the plurality of nozzle channels includes:
   A nozzle tapered portion having a channel area that gradually decreases from the first surface toward the second surface, the channel area being a cross-sectional area perpendicular to a droplet ejection direction; and
   A straight communication path that is continuous with a side facing the first surface of the nozzle tapered portion and includes a pair of facing surfaces substantially parallel to each other,
   Wherein
   The nozzle tapered portion and the straight communication path include a {111} plane.
(10) The nozzle plate according to (9), wherein the nozzle tapered portion and the straight communication path are composed of {111} planes.
(11) The nozzle plate according to (9) or (10),
   Wherein
   Each of the plurality of nozzle channels includes a nozzle straight portion on a side of the nozzle tapered portion facing the second surface, and
   A channel area of the nozzle straight portion is less than or equal to the channel area of the nozzle tapered portion.
(12) The nozzle plate according to (11), further comprising
   A non-wet etching layer formed by masking, thermal oxidation, or high-concentration doping,
   Wherein
   The nozzle straight portion has the non-wet etching layer for an end portion on a side facing the first surface.
(13) The nozzle plate according to (11) or (12), wherein the nozzle straight portion is continuous with an end portion of the nozzle tapered portion on the side facing the second surface.
(14) The nozzle plate according to any one of (11) to (13), wherein in a view from the first surface, at least a portion of a ridgeline on a side facing the first surface among ridgelines constituting the nozzle straight portion is substantially in contact with a surface substantially perpendicular to the first surface among surfaces constituting the nozzle straight communication path.
(15) The nozzle plate according to any one of (5) to (8) and (11) to (14),
   Wherein
   In a view from the first surface, an absolute value of a difference between a first distance and a second distance is within 0.5 µm, where the first distance is a distance from an intersection line to a farthest point or line on a ridgeline in a first direction parallel to the first surface or the second surface among <100> directions, the intersection line being where two tapered surfaces constituting the nozzle tapered portion intersect when virtually extended, the ridgeline being where a surface constituting the nozzle straight portion intersects with the two tapered surfaces constituting the nozzle tapered portion, and
   The second distance is a distance from the intersection line to a farthest point or line on the ridgeline in a second direction parallel to the first surface or the second surface among <100> directions.
(16) A droplet ejection head comprising the nozzle plate according to any one of (1) to (15).
(17) A droplet ejection apparatus comprising the droplet ejection head according to (16).
(18) A method for manufacturing a nozzle plate of a droplet ejection head, comprising:
   A first step of forming a front mask layer on a first surface of a single-crystal silicon substrate having a {110} surface crystal orientation;
   A second step of forming an opening pattern that yields an opening of a nozzle channel in the front mask layer; and
   A third step of performing anisotropic wet etching on the single-crystal silicon substrate from a surface through the opening pattern.
(19) The method for manufacturing the nozzle plate according to (18), wherein in the third step, a nozzle tapered portion having a channel area that gradually decreases from the first surface toward a second surface opposite the first surface is formed, the channel area being a cross-sectional area perpendicular to a droplet ejection direction.
(20) The method for manufacturing the nozzle plate according to (19),
   Wherein
   The first step includes forming a back mask layer on the second surface of the single-crystal silicon substrate, and
   The method further comprises:
      A fourth step of forming a nozzle pattern that yields a nozzle in the back mask layer; and
      A fifth step of forming a nozzle straight portion by performing penetration processing on the single-crystal silicon substrate from a surface through the nozzle pattern by dry etching, the fourth step and the fifth step being performed after the third step.
(21) A method for manufacturing a nozzle plate of a droplet ejection head, comprising:
   A first step of forming a front mask layer on a first surface of a single-crystal silicon substrate having a {110} surface crystal orientation, and a back mask layer on a second surface of the single-crystal silicon substrate opposite the first surface;
   A second step of forming a nozzle pattern that yields a nozzle in the back mask layer;
   A third step of forming a deep hole that yields a nozzle straight portion by performing deep etching on the single-crystal silicon substrate from a back surface through the nozzle pattern to a middle by dry etching;
   A fourth step of forming a nozzle mask layer on a side wall of the deep hole;
   A fifth step of performing deep etching on the single-crystal silicon substrate from the back surface through the deep hole by dry etching;
   A sixth step of forming an opening pattern that yields an opening in the front mask layer;
   A seventh step of performing deep etching on the single-crystal silicon substrate from a front surface through the opening pattern by dry etching; and
   An eighth step of performing penetration processing on the single-crystal silicon substrate from the front surface and the back surface by anisotropic wet etching to form a nozzle channel that includes a nozzle straight portion, a nozzle tapered portion, and a straight communication path,
   Wherein
   A depth H of a deep hole formed in the seventh step satisfies the following (1):
      (1) T-(H + (L/2) tan θ) ≥ h-(D/2) tan θ, where a thickness of the single-crystal silicon substrate is T, a diameter of the nozzle straight portion is D, a depth of the nozzle straight portion is h, a width of the opening in a <110> direction is L, and an angle formed by the first and second surfaces of the single-crystal silicon substrate and two tapered surfaces of {111} planes constituting the nozzle tapered portion is θ (θ = cos⁻¹ (2/√6) ≈ 35.26°).
(22) The method for manufacturing the nozzle plate according to (21), wherein when the first surface is set to a (110) plane, a width of the nozzle pattern formed in the second step in a [-111] direction and a width of the nozzle pattern in a [1-1-1] direction are wider than a width of the opening pattern formed in the sixth step in a [-111] direction and a width of the opening pattern in a [1-1-1] direction.

### Reference Signs List

B single-crystal silicon substrate
Ba bonding surface (first surface)
Bb ejection surface (second surface)
1 inkjet recording apparatus (droplet ejecting apparatus)
10 inkjet head (droplet ejection head)
110 nozzle plate
111 nozzle channel
1111 nozzle straight portion
1112 nozzle tapered portion
1113 straight communication path
112 front mask layer
113 back mask layer
114 opening pattern
115 nozzle pattern
116 nozzle mask layer
N nozzle

## Claims

1. A nozzle plate (110) made of a single-crystal silicon substrate (B), comprising
a plurality of nozzle channels (111) that penetrates the nozzle plate (110), the plurality of nozzle channels (111) each including a nozzle (N) and each capable of ejecting droplets from the nozzle (N),
wherein
the single-crystal silicon substrate (B) includes a first surface (Ba) and a second surface (Bb) opposite the first surface (Ba),
the nozzle (N) is formed on the second surface (Bb), and
the first surface (Ba) and the second surface (Bb) are {110} planes,
wherein
each of the plurality of nozzle channels (111) includes a nozzle tapered portion (1112) having a channel area that gradually decreases from the first surface (Ba) toward the second surface (Bb), the channel area being a cross-sectional area perpendicular to a droplet ejection direction, and
the nozzle tapered portion (1112) includes a {111} plane,
each of the plurality of nozzle channels (111) includes a nozzle straight portion (1111) on a side of the nozzle tapered portion (1112) facing the second surface (Bb), and
a channel area of the nozzle straight portion (1111) is less than or equal to the channel area of the nozzle tapered portion (1112), **characterized in that**
in a view from the first surface (Ba), at least a portion of a ridgeline on a side facing the first surface (Ba) among ridgelines constituting the nozzle straight portion (1111) is substantially in contact with a surface substantially perpendicular to the first surface (Ba) among surfaces constituting the nozzle tapered portion (1112).

2. The nozzle plate (110) according to claim 1, wherein the nozzle tapered portion (1112) is composed of {111} planes.

3. A nozzle plate (110) made of a single-crystal silicon substrate (B), comprising
a plurality of nozzle channels (111) that penetrates the nozzle plate (110), the plurality of nozzle channels (111) each including a nozzle (N) and each capable of ejecting droplets from the nozzle (N),
wherein
the single-crystal silicon substrate (B) includes a first surface (Ba) and a second surface (Bb) opposite the first surface (Ba),
the nozzle (N) is formed on the second surface (Bb), and
the first surface (Ba) and the second surface (Bb) are {110} planes,
wherein
each of the plurality of nozzle channels (111) includes:
a nozzle tapered portion (1112) having a channel area that gradually decreases from the first surface (Ba) toward the second surface (Bb), the channel area being a cross-sectional area perpendicular to a droplet ejection direction; and
a straight communication path (1113) that is continuous with a side of the nozzle tapered portion (1112) facing the first surface (Ba) and includes a pair of facing surfaces substantially parallel to each other,
wherein
the nozzle tapered portion (1112) and the straight communication path (1113) include a {111} plane,
each of the plurality of nozzle channels (111) includes a nozzle straight portion (1111) on a side of the nozzle tapered portion (1112) facing the second surface (Bb),
a channel area of the nozzle straight portion (1111) is less than or equal to the channel area of the nozzle tapered portion (1112); **characterized in that**
in a view from the first surface (Ba), at least a portion of a ridgeline on a side facing the first surface (Ba) among ridgelines constituting the nozzle straight portion (1111) is substantially in contact with a surface substantially perpendicular to the first surface (Ba) among surfaces constituting the nozzle straight communication path (1113).

4. The nozzle plate (110) according to claim 3, wherein the nozzle tapered portion (1112) and the straight communication path (1113) are composed of {111} planes.

5. The nozzle plate (110) according to any one of the previous claims 3 or 4, further comprising
a non-wet etching layer formed by masking, thermal oxidation, or high-concentration doping,
wherein
the nozzle straight portion (1111) has the non-wet etching layer for an end portion on a side facing the first surface (Ba).

6. The nozzle plate (110) according to any one of previous claims, wherein the nozzle straight portion (1111) is continuous with an end portion of the nozzle tapered portion (1112) on the side facing the second surface (Bb).

7. The nozzle plate (110) according to any one of the previous claims, wherein each of the plurality of nozzle channels (111) includes a surface on a {111} plane.

8. The nozzle plate (110) according to any one of the previous claims,
wherein
in a view from the first surface (Ba), an absolute value of a difference between a first distance and a second distance is within 0.5 µm, where the first distance is a distance from an intersection line to a farthest point or line on a ridgeline in a first direction parallel to the first surface (Ba) or the second surface (Bb) among <100> directions, the intersection line being where two tapered surfaces constituting the nozzle tapered portion (1112) intersect when virtually extended, the ridgeline being where a surface constituting the nozzle straight portion (1111) intersects with the two tapered surfaces constituting the nozzle tapered portion (1112), and
the second distance is a distance from the intersection line to a farthest point or line on the ridgeline in a second direction parallel to the first surface (Ba) or the second surface (Bb) among <100> directions.

9. A droplet ejection head (10) comprising the nozzle plate (110) according to any one of claims 1 to 8.

10. A droplet ejection apparatus (1) comprising the droplet ejection head (17) according to claim 9.

11. A method for manufacturing a nozzle plate (110) of a droplet ejection head (10), comprising:
a first step of forming a front mask layer on a first surface (Ba) of a single-crystal silicon substrate (B) having a {110} surface crystal orientation;
a second step of forming an opening pattern (114) that yields an opening of a nozzle channel (111) in the front mask layer (112); and
a third step of performing anisotropic wet etching on the single-crystal silicon substrate (B) from a surface through the opening pattern (114), wherein, a nozzle tapered portion (1112) having a channel area that gradually decreases from the first surface (Ba) toward a second surface (Bb) of the single-crystal silicon substrate (B) opposite the first surface (Ba) is formed, the channel area being a cross-sectional area perpendicular to a droplet ejection direction, and
wherein
the first step of forming the front mask layer (112) includes forming a back mask layer (113) on the second surface (Ba) of the single-crystal silicon substrate (B), and
the method further comprises:
a fourth step of forming a nozzle pattern (115) that yields a nozzle (N) in the back mask layer (113); and
a fifth step of forming a nozzle straight portion (1111) by performing penetration processing on the single-crystal silicon substrate (B) from a surface through the nozzle pattern (115) by dry etching, the fourth step of forming the nozzle pattern (115) and the fifth step of forming the nozzle straight portion (1111) being performed after the third step of the performing anisotropic wet etching, wherein in a view from the first surface (Ba), at least a portion of a ridgeline on a side facing the first surface (Ba) among ridgelines constituting the nozzle straight portion (1111) is substantially in contact with a surface substantially perpendicular to the first surface (Ba) among surfaces constituting the nozzle tapered portion (1112).

12. A method for manufacturing a nozzle plate (110) of a droplet ejection head (10), comprising:
a first step of forming a front mask layer (112) on a first surface (Ba) of a single-crystal silicon substrate (B) having a {110} surface crystal orientation, and a back mask layer (113) on a second surface (Bb) of the single-crystal silicon substrate (B) opposite the first surface (Ba);
a second step of forming a nozzle pattern (115) that yields a nozzle (N) in the back mask layer (113);
a third step of forming a hole that yields a nozzle straight portion (1111) by performing dry etching on the single-crystal silicon substrate (B) from a back surface through the nozzle pattern (115) to a middle;
a fourth step of forming a nozzle mask layer (116) on a side wall of the hole;
a firth step of performing dry etching the single-crystal silicon substrate (B) from the back surface through the hole;
a sixth step of forming an opening pattern (114) that yields an opening in the front mask layer (112);
a seventh step of performing dry etching on the single-crystal silicon substrate (B) from a front surface through the opening pattern (114); and
an eight step of performing penetration processing on the single-crystal silicon substrate (B) from the front surface and the back surface by anisotropic wet etching to form a nozzle channel (111) that includes a nozzle straight portion (1111), a nozzle tapered portion (1112), and a straight communication path (1113),
wherein
a depth H of a hole formed in the performing dry etching on the single-crystal silicon substrate from the front surface satisfies the following (1):
(1) T-(H + (L/2) tan θ) ≥ h-(D/2) tan θ, where a thickness of the single-crystal silicon substrate (B) is T, a diameter of the nozzle straight portion (1111) is D, a depth of the nozzle straight portion (1111) is h, a width of the opening in a <110> direction is L, and an angle formed by the first and second surfaces (Ba, Bb) of the single-crystal silicon substrate (B) and two tapered surfaces of {111} planes constituting the nozzle tapered portion (1112) is θ (θ = cos⁻¹ (2/√6) ≈ 35.26°), and
in a view from the first surface (Ba), at least a portion of a ridgeline on a side facing the first surface (Ba) among ridgelines constituting the nozzle straight portion (1111) is substantially in contact with a surface substantially perpendicular to the first surface (Ba) among surfaces constituting the nozzle straight communication path (1113).

13. The method for manufacturing the nozzle plate (110) according to claim 12, wherein when the first surface (Ba) is set to a (110) plane, a width of the nozzle pattern (115) formed in the forming the nozzle pattern (115) in a [-111] direction and a width of the nozzle pattern (115) in a [1-1-1] direction are wider than a width of the opening pattern (114) formed in the forming the opening pattern (114) in a [-111] direction and a width of the opening pattern (114) in a [1-1-1] direction.

## Patentansprüche

1. Düsenplatte (110) aus einem einkristallinen Siliziumsubstrat (B), umfassend
eine Vielzahl von Düsenkanälen (111), die die Düsenplatte (110) durchdringen, wobei jeder der Vielzahl von Düsenkanälen (111) eine Düse (N) umfasst und in der Lage ist, Tröpfchen aus der Düse (N) auszustoßen,
wobei
das einkristalline Siliziumsubstrat (B) eine erste Oberfläche (Ba) und eine der ersten Oberfläche (Ba) gegenüberliegende zweite Oberfläche (Bb) umfasst,
die Düse (N) auf der zweiten Oberfläche (Bb) ausgebildet ist, und
die erste Oberfläche (Ba) und die zweite Oberfläche (Bb) {110}-Ebenen sind,
wobei
jeder der Vielzahl von Düsenkanälen (111) einen sich verjüngenden Düsenabschnitt (1112) mit einer von der ersten Oberfläche (Ba) zur zweiten Oberfläche (Bb) hin allmählich abnehmenden Kanalfläche aufweist, wobei die Kanalfläche eine Querschnittsfläche senkrecht zu einer Tröpfchenausstoßrichtung ist, und
der sich verjüngende Düsenabschnitt (1112) eine {111}-Ebene umfasst,
jeder der Vielzahl von Düsenkanälen (111) einen geradlinigen Düsenabschnitt (1111) an einer der zweiten Oberfläche (Bb) zugewandten Seite des sich verjüngenden Düsenabschnitts (1112) umfasst, und
eine Kanalfläche des geradlinigen Düsenabschnitts (1111) kleiner oder gleich der Kanalfläche des sich verjüngenden Düsenabschnitts (1112) ist, **dadurch gekennzeichnet, dass**
in einer Ansicht von der ersten Oberfläche (Ba) aus mindestens ein Abschnitt einer Gratlinie, unter Gratlinien, die den geradlinigen Düsenabschnitt (1111) bilden, an einer der ersten Oberfläche (Ba) zugewandten Seite im Wesentlichen in Kontakt mit einer Fläche steht, die im Wesentlichen senkrecht zur ersten Oberfläche (Ba) ist, unter Flächen, die den sich verjüngenden Düsenabschnitt (1112) bilden.

2. Düsenplatte (110) gemäß Anspruch 1, wobei der sich verjüngende Düsenabschnitt (1112) aus {111}-Ebenen besteht.

3. Düsenplatte (110) aus einem einkristallinen Siliziumsubstrat (B), umfassend
eine Vielzahl von Düsenkanälen (111), die die Düsenplatte (110) durchdringen, wobei jeder der Vielzahl von Düsenkanälen (111) eine Düse (N) umfasst und in der Lage ist, Tröpfchen aus der Düse (N) auszustoßen,
wobei
das einkristalline Siliziumsubstrat (B) eine erste Oberfläche (Ba) und eine der ersten Oberfläche (Ba) gegenüberliegende zweite Oberfläche (Bb) aufweist,
die Düse (N) auf der zweiten Oberfläche (Bb) ausgebildet ist, und
die erste Oberfläche (Ba) und die zweite Oberfläche (Bb) {110}-Ebenen sind,
wobei
jeder der Vielzahl von Düsenkanälen (111) umfasst:
einen sich verjüngenden Düsenabschnitt (1112) mit einer von der ersten Oberfläche (Ba) zur zweiten Oberfläche (Bb) hin allmählich abnehmenden Kanalfläche aufweist, wobei die Kanalfläche eine Querschnittsfläche senkrecht zu einer Tröpfchenausstoßrichtung ist; und
einen geradlinigen Verbindungsweg (1113), der an eine der ersten Oberfläche (Ba) zugewandte Seite des sich verjüngenden Düsenabschnitts (1112) anschließt und ein Paar einander gegenüberliegender, im Wesentlichen zueinander paralleler Flächen umfasst,
wobei
der sich verjüngende Düsenabschnitt (1112) und der geradlinige Verbindungsweg (1113) eine {111}-Ebene umfassen,
jeder der Vielzahl von Düsenkanälen (111) einen geradlinigen Düsenabschnitt (1111) an einer Seite des sich verjüngenden Düsenabschnitts (1112) umfasst, die der zweiten Oberfläche (Bb) zugewandt ist,
eine Kanalfläche des geradlinigen Düsenabschnitts (1111) kleiner oder gleich der Kanalfläche des sich verjüngenden Düsenabschnitts (1112) ist; **dadurch gekennzeichnet, dass**
in einer Ansicht von der ersten Oberfläche (Ba) aus mindestens ein Abschnitt einer Gratlinie, unter Gratlinien, die den geradlinigen Düsenabschnitt (1111) bilden, an einer der ersten Oberfläche (Ba) zugewandten Seite im Wesentlichen in Kontakt mit einer Fläche steht, die im Wesentlichen senkrecht zur ersten Oberfläche (Ba) ist, unter Flächen, die den geradlinigen Düsenverbindungsweg (1113) bilden.

4. Düsenplatte (110) gemäß Anspruch 3, wobei der sich verjüngende Düsenabschnitt (1112) und der geradlinige Verbindungsweg (1113) aus {111}-Ebenen bestehen.

5. Düsenplatte (110) gemäß einem der vorstehenden Ansprüche 3 oder 4, ferner umfassend
eine nicht-nassätzbare Schicht, die durch Maskierung, thermische Oxidation oder hochkonzentrierte Dotierung gebildet ist,
wobei
der geradlinige Düsenabschnitt (1111) die nicht-nassätzbare Schicht für einen Endabschnitt an einer der ersten Oberfläche (Ba) zugewandten Seite aufweist.

6. Düsenplatte (110) gemäß einem der vorstehenden Ansprüche, wobei der geradlinige Düsenabschnitt (1111) an einen Endabschnitt des sich verjüngenden Düsenabschnitts (1112) auf der der zweiten Oberfläche (Bb) zugewandten Seite anschließt.

7. Düsenplatte (110) gemäß einem der vorstehenden Ansprüche, wobei jeder der Vielzahl von Düsenkanälen (111) eine Fläche auf einer {111}-Ebene umfasst.

8. Düsenplatte (110) gemäß einem der vorstehenden Ansprüche,
wobei
in einer Ansicht von der ersten Oberfläche (Ba) aus ein Absolutwert einer Differenz zwischen einem ersten Abstand und einem zweiten Abstand 0,5 µm oder weniger beträgt, wobei der erste Abstand ein Abstand von einer Schnittlinie zu einem am weitesten entfernten Punkt oder einer am weitesten entfernten Linie auf einer Gratlinie in einer ersten Richtung parallel zur ersten Oberfläche (Ba) oder zur zweiten Oberfläche (Bb) unter <100>-Richtungen ist, wobei die Schnittlinie der Ort ist, an dem sich zwei sich verjüngende Flächen, die den sich verjüngenden Düsenabschnitt (1112) bilden, schneiden, wenn sie virtuell verlängert werden, wobei die Gratlinie der Ort ist, an dem eine Fläche, die den geradlinigen Düsenabschnitt (1111) bildet, die beiden sich verjüngenden Flächen schneidet, die den sich verjüngenden Düsenabschnitt (1112) bilden, und
wobei der zweite Abstand ein Abstand von der Schnittlinie zu einem am weitesten entfernten Punkt oder einer am weitesten entfernten Linie auf der Gratlinie in einer zweiten Richtung parallel zur ersten Oberfläche (Ba) oder zur zweiten Oberfläche (Bb) unter <100> Richtungen ist.

9. Tröpfchenausstoßkopf (10), der die Düsenplatte (110) gemäß einem der Ansprüche 1 bis 8 umfasst.

10. Tröpfchenausstoßvorrichtung (1), die den Tröpfchenausstoßkopf (17) gemäß Anspruch 9 umfasst.

11. Verfahren zur Herstellung einer Düsenplatte (110) eines Tröpfchenausstoßkopfes (10), umfassend:
einen ersten Schritt des Bildens einer vorderen Maskenschicht auf einer ersten Oberfläche (Ba) eines einkristallinen Siliziumsubstrats (B) mit einer {110}-Oberflächenkristallorientierung;
einen zweiten Schritt des Bildens eines Öffnungsmusters (114), wodurch eine Öffnung eines Düsenkanals (111) in der vorderen Maskenschicht (112) erzeugt wird; und
einen dritten Schritt des Durchführens eines anisotropen Nassätzens an dem einkristallinen Siliziumsubstrat (B) von einer Oberfläche durch das Öffnungsmuster (114) hindurch, wobei ein sich verjüngender Düsenabschnitt (1112) mit einer Kanalfläche, die von der ersten Oberfläche (Ba) hin zu einer der ersten Oberfläche (Ba) gegenüberliegenden zweiten Oberfläche (Bb) des einkristallinen Siliziumsubstrats (B) allmählich abnimmt, gebildet wird, wobei die Kanalfläche eine Querschnittsfläche senkrecht zu einer Tröpfchenausstoßrichtung ist, und
wobei
der erste Schritt des Bildens der vorderen Maskenschicht (112) das Bilden einer hinteren Maskenschicht (113) auf der zweiten Oberfläche (Bb) des einkristallinen Siliziumsubstrats (B) umfasst, und
das Verfahren ferner umfasst:
einen vierten Schritt des Bildens eines Düsenmusters (115), wodurch eine Düse (N) in der hinteren Maskenschicht (113) erzeugt wird; und
einen fünften Schritt des Bildens eines geradlinigen Düsenabschnitts (1111) durch Ausführen eines Durchdringungsvorgangs an dem einkristallinen Siliziumsubstrat (B) von einer Oberfläche durch das Düsenmuster (115) mittels Trockenätzen, wobei der vierte Schritt des Bildens des Düsenmusters (115) und der fünfte Schritt des Bildens des geradlinigen Düsenabschnitts (1111) nach dem dritten Schritt des Durchführens eines anisotropen Nassätzens durchgeführt werden, wobei in einer Ansicht von der ersten Oberfläche (Ba) aus mindestens ein Abschnitt einer Gratlinie an einer der ersten Oberfläche (Ba) zugewandten Seite unter Gratlinien, die den geradlinigen Düsenabschnitt (1111) bilden, im Wesentlichen in Kontakt mit einer Fläche steht, die im Wesentlichen senkrecht zur ersten Oberfläche (Ba) ist, unter Flächen, die den sich verjüngenden Düsenabschnitt (1112) bilden.

12. Verfahren zur Herstellung einer Düsenplatte (110) eines Tröpfchenausstoßkopfes (10), umfassend:
einen ersten Schritt des Bildens einer vorderen Maskenschicht (112) auf einer ersten Oberfläche (Ba) eines einkristallinen Siliziumsubstrats (B) mit einer {110}-Oberflächenkristallorientierung, und einer hinteren Maskenschicht (113) auf einer der ersten Oberfläche (Ba) gegenüberliegenden zweiten Oberfläche (Bb) des einkristallinen Siliziumsubstrats (B);
einen zweiten Schritt des Bildens eines Düsenmusters (115), wodurch eine Düse (N) in der hinteren Maskenschicht (113) erzeugt wird;
einen dritten Schritt des Bildens eines Lochs, wodurch ein geradliniger Düsenabschnitt (1111) erzeugt wird, durch Durchführen eines Trockenätzvorgangs an dem einkristallinen Siliziumsubstrat (B) von einer Rückseite durch das Düsenmuster (115) bis zu einer Mitte;
einen vierten Schritt des Bildens einer Düsenmaskenschicht (116) an einer Seitenwand des Lochs;
einen fünften Schritt des Durchführens einer Trockenätzung an dem einkristallinen Siliziumsubstrat (B) von der Rückseite durch das Loch;
einen sechsten Schritt des Bildens eines Öffnungsmusters (114), wodurch eine Öffnung in der vorderen Maskenschicht (112) erzeugt wird;
einen siebten Schritt des Durchführens einer Trockenätzung an dem einkristallinen Siliziumsubstrat (B) von einer Vorderseite durch das Öffnungsmuster (114); und
einen achten Schritt des Durchführens eines Durchdringungsvorgangs an dem einkristallinen Siliziumsubstrat (B) von der Vorderseite und der Rückseite durch anisotropes Nassätzen, um einen Düsenkanal (111) zu bilden, der einen geradlinigen Düsenabschnitt (1111), einen sich verjüngenden Düsenabschnitt (1112) und einen geradlinigen Verbindungsweg (1113) umfasst,
wobei
eine Tiefe H eines Lochs, das beim Durchführen der Trockenätzung an dem einkristallinen Siliziumsubstrat von der Vorderseite aus gebildet wird, die folgende Gleichung (1) erfüllt:
(1) T-(H + (L/2) tan θ) ≥ h-(D/2) tan θ, wobei T eine Dicke des einkristallinen Siliziumsubstrats (B) ist, D ein Durchmesser des geradlinigen Düsenabschnitts (1111) ist, h eine Tiefe des geradlinigen Düsenabschnitts (1111) ist, L eine Breite der Öffnung in einer <110>-Richtung ist, und wobei ein Winkel, der durch die erste und zweite Oberfläche (Ba, Bb) des einkristallinen Siliziumsubstrats (B) und zwei sich verjüngende Flächen von {111}-Ebenen gebildet wird, die den sich verjüngenden Düsenabschnitt (1112) bilden, θ beträgt (θ = cos⁻¹ (2/√6) ≈ 35,26°), und
in einer Ansicht von der ersten Oberfläche (Ba) aus mindestens ein Teil einer Gratlinie an einer der ersten Oberfläche (Ba) zugewandten Seite unter Gratlinien, die den geradlinigen Düsenabschnitt (1111) bilden, im Wesentlichen in Kontakt mit einer Fläche steht, die im Wesentlichen senkrecht zur ersten Oberfläche (Ba) ist, unter Flächen, die den geradlinigen Düsenverbindungsweg (1113) bilden.

13. Verfahren zur Herstellung der Düsenplatte (110) gemäß Anspruch 12, wobei, wenn die erste Oberfläche (Ba) auf eine (110)-Ebene festgelegt ist, eine Breite des Düsenmusters (115), das beim Bilden des Düsenmusters (115) in einer [-111]-Richtung gebildet wird, und eine Breite des Düsenmusters (115) in einer [1-1-1]-Richtung breiter sind als eine Breite des Öffnungsmusters (114), das beim Bilden des Öffnungsmusters (114) in einer [-111]-Richtung gebildet wird, und eine Breite des Öffnungsmusters (114) in einer [1-1-1]-Richtung.

## Revendications

1. Plaque de buse (110) réalisée en un substrat de silicium monocristallin (B), comprenant
une pluralité de canaux de buse (111) qui traversent la plaque de buse (110), la pluralité de canaux de buse (111) comprenant chacun une buse (N) et étant chacun capable d'éjecter des gouttelettes à partir de la buse (N),
dans laquelle
le substrat de silicium monocristallin (B) comprend une première surface (Ba) et une seconde surface (Bb) opposée à la première surface (Ba),
la buse (N) est formée sur la seconde surface (Bb), et
la première surface (Ba) et la seconde surface (Bb) sont des plans {110},
dans laquelle
chacun de la pluralité de canaux de buse (111) comprend une partie conique de buse (1112) présentant une aire de canal qui diminue progressivement de la première surface (Ba) vers la seconde surface (Bb), l'aire de canal étant une aire de section transversale perpendiculaire à une direction d'éjection de gouttelettes, et
la partie conique de buse (1112) comprend un plan {111},
chacun de la pluralité de canaux de buse (111) comprend une partie rectiligne de buse (1111) sur un côté de la partie conique de buse (1112) faisant face à la seconde surface (Bb), et
une aire de canal de la partie rectiligne de buse (1111) est inférieure ou égale à l'aire de canal de la partie conique de buse (1112), **caractérisée en ce que**
dans une vue depuis la première surface (Ba), au moins une partie d'une ligne de crête située d'un côté faisant face à la première surface (Ba) parmi des lignes de crête constituant la partie rectiligne de buse (1111) est sensiblement en contact avec une surface sensiblement perpendiculaire à la première surface (Ba) parmi des surfaces constituant la partie conique de buse (1112).

2. Plaque de buse (110) selon la revendication 1, dans laquelle la partie conique de buse (1112) est composée de plans {111}.

3. Plaque de buse (110) réalisée en un substrat de silicium monocristallin (B), comprenant
une pluralité de canaux de buse (111) qui traversent la plaque de buse (110), la pluralité de canaux de buse (111) comprenant chacun une buse (N) et étant chacun capable d'éjecter des gouttelettes à partir de la buse (N),
dans laquelle
le substrat de silicium monocristallin (B) comprend une première surface (Ba) et une seconde surface (Bb) opposée à la première surface (Ba),
la buse (N) est formée sur la seconde surface (Bb), et
la première surface (Ba) et la seconde surface (Bb) sont des plans {110},
dans laquelle
chacun de la pluralité de canaux de buse (111) comprend :
une partie conique de buse (1112) présentant une aire de canal qui diminue progressivement de la première surface (Ba) vers la seconde surface (Bb), l'aire de canal étant une aire de section transversale perpendiculaire à une direction d'éjection de gouttelettes, et
un chemin de communication rectiligne (1113) qui est continu avec un côté de la partie conique de buse (1112) faisant face à la première surface (Ba) et qui comprend une paire de surfaces opposées sensiblement parallèles l'une à l'autre,
dans laquelle
la partie conique de buse (1112) et le chemin de communication rectiligne (1113) comprennent un plan {111},
chacun de la pluralité de canaux de buse (111) comprend une partie rectiligne de buse (1111) sur un côté de la partie conique de buse (1112) faisant face à la seconde surface (Bb),
une aire de canal de la partie rectiligne de buse (1111) est inférieure ou égale à l'aire de canal de la partie conique de buse (1112) ; **caractérisée en ce que**
dans une vue depuis la première surface (Ba), au moins une partie d'une ligne de crête située d'un côté faisant face à la première surface (Ba) parmi des lignes de crête constituant la partie rectiligne de buse (1111) est sensiblement en contact avec une surface sensiblement perpendiculaire à la première surface (Ba) parmi des surfaces constituant le chemin de communication rectiligne de buse (1113).

4. Plaque de buse (110) selon la revendication 3, dans laquelle la partie conique de buse (1112) et le chemin de communication rectiligne (1113) sont composés de plans {111}.

5. Plaque de buse (110) selon l'une des revendications 3 ou 4 précédentes, comprenant en outre
une couche non gravable par gravure humide formée par masquage, oxydation thermique ou dopage à haute concentration,
dans laquelle
la partie rectiligne de buse (1111) comporte la couche non gravable par gravure humide pour une partie d'extrémité sur un côté faisant face à la première surface (Ba).

6. Plaque de buse (110) selon l'une des revendications précédentes, dans laquelle la partie rectiligne de buse (1111) est continue avec une partie d'extrémité de la partie conique de buse (1112) du côté faisant face à la seconde surface (Bb).

7. Plaque de buse (110) selon l'une des revendications précédentes, dans laquelle chacun de la pluralité de canaux de buse (111) comprend une surface sur un plan {111}.

8. Plaque de buse (110) selon l'une des revendications précédentes,
dans laquelle
dans une vue depuis la première surface (Ba), une valeur absolue d'une différence entre une première distance et une seconde distance est inférieure ou égale à 0,5 µm, la première distance étant une distance depuis une ligne d'intersection jusqu'à un point le plus éloigné ou une ligne la plus éloignée sur une ligne de crête dans une première direction parallèle à la première surface (Ba) ou à la seconde surface (Bb) parmi des directions <100>, la ligne d'intersection étant l'endroit où deux surfaces coniques constituant la partie conique de buse (1112) se croisent lorsqu'elles sont prolongées virtuellement, la ligne de crête étant l'endroit où une surface constituant la partie rectiligne de buse (1111) croise les deux surfaces coniques constituant la partie conique de buse (1112), et
la seconde distance est une distance depuis la ligne d'intersection jusqu'à un point le plus éloigné ou une ligne la plus éloignée sur la ligne de crête dans une seconde direction parallèle à la première surface (Ba) ou à la seconde surface (Bb) parmi des directions <100>.

9. Tête d'éjection de gouttelettes (10) comprenant la plaque de buse (110) selon l'une des revendications 1 à 8.

10. Appareil d'éjection de gouttelettes (1) comprenant la tête d'éjection de gouttelettes (17) selon la revendication 9.

11. Procédé de fabrication d'une plaque de buse (110) d'une tête d'éjection de gouttelettes (10), comprenant :
une première étape consistant à former une couche de masque avant sur une première surface (Ba) d'un substrat de silicium monocristallin (B) présentant une orientation cristalline de surface {110} ;
une deuxième étape consistant à former un motif d'ouverture (114) qui fournit une ouverture d'un canal de buse (111) dans la couche de masque avant (112) ; et
une troisième étape consistant à effectuer une gravure humide anisotrope sur le substrat de silicium monocristallin (B) à partir d'une surface à travers le motif d'ouverture (114), où une partie conique de buse (1112) présentant une aire de canal qui diminue progressivement de la première surface (Ba) vers une seconde surface (Bb) du substrat de silicium monocristallin (B) opposée à la première surface (Ba) est formée, l'aire de canal étant une aire de section transversale perpendiculaire à une direction d'éjection de gouttelettes, et
dans lequel
la première étape de formation de la couche de masque avant (112) comprend la formation d'une couche de masque arrière (113) sur la seconde surface (Bb) du substrat de silicium monocristallin (B), et
le procédé comprend en outre :
une quatrième étape consistant à former un motif de buse (115) qui fournit une buse (N) dans la couche de masque arrière (113) ; et
une cinquième étape consistant à former une partie rectiligne de buse (1111) en réalisant un traitement de pénétration sur le substrat de silicium monocristallin (B) depuis une surface à travers le motif de buse (115) par gravure sèche, la quatrième étape de formation du motif de buse (115) et la cinquième étape de formation de la partie rectiligne de buse (1111) étant réalisées après la troisième étape de gravure humide anisotrope, dans lequel, dans une vue depuis la première surface (Ba), au moins une partie d'une ligne de crête sur un côté faisant face à la première surface (Ba) parmi des lignes de crête constituant la partie rectiligne de buse (1111) est sensiblement en contact avec une surface sensiblement perpendiculaire à la première surface (Ba) parmi des surfaces constituant la partie conique de buse (1112).

12. Procédé de fabrication d'une plaque de buse (110) d'une tête d'éjection de gouttelettes (10), comprenant :
une première étape consistant à former une couche de masque avant (112) sur une première surface (Ba) d'un substrat de silicium monocristallin (B) présentant une orientation cristalline de surface {110}, et une couche de masque arrière (113) sur une seconde surface (Bb) du substrat de silicium monocristallin (B) opposée à la première surface (Ba) ;
une deuxième étape consistant à former un motif de buse (115) qui fournit une buse (N) dans la couche de masque arrière (113) ;
une troisième étape consistant à former un trou qui fournit une partie rectiligne de buse (1111) en effectuant une gravure sèche sur le substrat de silicium monocristallin (B) depuis une surface arrière à travers le motif de buse (115) jusqu'à un milieu ;
une quatrième étape consistant à former une couche de masque de buse (116) sur une paroi latérale du trou ;
une cinquième étape consistant à effectuer une gravure sèche du substrat de silicium monocristallin (B) depuis la surface arrière à travers le trou ;
une sixième étape consistant à former un motif d'ouverture (114) qui fournit une ouverture dans la couche de masque avant (112) ;
une septième étape consistant à effectuer une gravure sèche sur le substrat de silicium monocristallin (B) depuis une surface avant à travers le motif d'ouverture (114) ; et
une huitième étape consistant à effectuer un traitement de pénétration sur le substrat de silicium monocristallin (B) depuis la surface avant et la surface arrière par gravure humide anisotrope afin de former un canal de buse (111) qui comprend une partie rectiligne de buse (1111), une partie conique de buse (1112) et un chemin de communication rectiligne (1113),
dans lequel
une profondeur H d'un trou formé lors de l'étape consistant à effectuer la gravure sèche sur le substrat de silicium monocristallin à partir de la surface avant satisfait à la relation (1) suivante :
(1) T-(H + (L/2) tan θ) ≥ h-(D/2) tan θ, où une épaisseur du substrat de silicium monocristallin (B) est T, un diamètre de la partie rectiligne de buse (1111) est D, une profondeur de la partie rectiligne de buse (1111) est h, une largeur de l'ouverture dans une direction <110> est L, et un angle formé par les première et seconde surfaces (Ba, Bb) du substrat de silicium monocristallin (B) et deux surfaces coniques des plans {111} constituant la partie conique de buse (1112) est θ (θ = cos⁻¹ (2/√6) ≈ 35.26°), et
dans une vue depuis la première surface (Ba), au moins une partie d'une ligne de crête sur un côté faisant face à la première surface (Ba) parmi des lignes de crête constituant la partie rectiligne de buse (1111) est sensiblement en contact avec une surface sensiblement perpendiculaire à la première surface (Ba) parmi des surfaces constituant le chemin de communication rectiligne de buse (1113).

13. Procédé de fabrication de la plaque de buse (110) selon la revendication 12, dans lequel, lorsque la première surface (Ba) est définie comme un plan (110), une largeur du motif de buse (115) formé lors de l'étape de formation du motif de buse (115) dans une direction [-111] et une largeur du motif de buse (115) dans une direction [1-1-1] sont plus grandes qu'une largeur du motif d'ouverture (114) formé lors de l'étape de formation du motif d'ouverture (114) dans une direction [-111] et qu'une largeur du motif d'ouverture (114) dans une direction [1-1-1].
